(19) Europäisches Patentamt
European Patent Office
Office européen des brevets

(11) EP 1 767 991 B1

(12) **EUROPEAN PATENT SPECIFICATION**

(45) Date of publication and mention of the grant of the patent:
**17.04.2013 Bulletin 2013/16**

(51) Int Cl.:
***G03F 7/004*** *(2006.01)* ***G03F 7/039*** *(2006.01)*

(21) Application number: **06019989.0**

(22) Date of filing: **25.09.2006**

(54) **Positive resist composition and pattern forming method using the same**

Positive Resistzusammensetzung und Verfahren zur Strukturformung unter Verwendung derselben

Composition de réserve positive et procédé de formation de motif l'utilisant

(84) Designated Contracting States:
**AT BE BG CH CY CZ DE DK EE ES FI FR GB GR HU IE IS IT LI LT LU LV MC NL PL PT RO SE SI SK TR**

(30) Priority: **26.09.2005 JP 2005277528**

(43) Date of publication of application:
**28.03.2007 Bulletin 2007/13**

(73) Proprietor: **FUJIFILM Corporation**
**Minato-ku**
**Tokyo (JP)**

(72) Inventors:
- **Mizutani, Kazuyoshi**
**Yoshida-cho**
**Haibara-gun**
**Shizuoka (JP)**
- **Kawanishi, Yasutomo**
**Yoshida-cho**
**Haibara-gun**
**Shizuoka (JP)**

(74) Representative: **HOFFMANN EITLE**
**Patent- und Rechtsanwälte**
**Arabellastrasse 4**
**81925 München (DE)**

(56) References cited:
**EP-A- 1 703 326** **US-A- 6 093 517**
**US-B1- 6 197 473**

- **L.F. THOMPSON ET AL.: "Introduction to Microlithography" 1994, AMERCAN CHEMICAL SOCIETY , USA , XP002450917 * page 227; figure 86 ***

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

FIELD OF THE INVENTION

The present invention relates to a positive resist composition suitably used in the ultramicrolithography process for the production or the like of VLSI or high-capacity microchip or in other photofabrication processes, and a pattern forming method using the composition. More specifically, the present invention relates to a positive resist composition capable of forming a highly refined pattern with use of electron beam, X-ray, EUV light or the like, and a pattern forming method using the composition, that is, the present invention relates to a positive resist composition suitably usable for fine processing of a semiconductor device, where electron beam, X-ray or EUV light is used, and a pattern forming method using the composition.

BACKGROUND OF THE INVENTION

In the process of producing a semiconductor device such as IC and LSI, fine processing by lithography using a resist composition has been conventionally performed. Recently, the integration degree of an integrated circuit is becoming higher and formation of an ultrafine pattern in the sub-micron or quarter-micron region is required. To cope with this requirement, the exposure wavelength also tends to become shorter, for example, from g line to i line or further to KrF excimer laser light. At present, other than the excimer laser light, development of lithography using electron beam, X-ray or EUV light is proceeding.

Among these, the electron beam lithography is positioned as a next-generation or next-next-generation pattern formation technique and a positive resist with high sensitivity and high resolution is being demanded. In particular, the elevation of sensitivity for shortening the wafer processing time is very important but in the positive resist for use with electron beam, when elevation of sensitivity is sought for, not only reduction of resolving power but also worsening of line edge roughness are brought about and development of a resist satisfying these properties at the same time is strongly demanded. The line edge roughness as used herein means that the resist edge at the interface between the pattern and the substrate irregularly fluctuates in the direction perpendicular to the line direction due to the resist property and when the pattern is viewed from right above, the edge gives an uneven appearance. This unevenness is transferred by the etching step using the resist as a mask and causes deterioration of electric property, resulting in decrease in the yield. Particularly, in an ultrafine region of 0.25 μm or less, the improvement of line edge roughness is an essential problem to be solved. The high sensitivity is in a trade-off relationship with high resolution, good pattern profile and good line edge roughness and it is very important how to satisfy these matters at the same time.

Furthermore, also in the lithography using X-ray or EUV light, it is similarly important to satisfy high sensitivity, high resolution and the like at the same time, and this problem needs to be solved.

As for the resist suitable for such a lithography process using electron beam, X-ray or EUV light, a chemical amplification-type resist utilizing an acid catalytic reaction is mainly used from the standpoint of elevating the sensitivity and in the case of a positive resist, a chemical amplification-type resist composition mainly comprising an acid generator and a phenolic polymer which is insoluble or sparingly soluble in an aqueous alkali solution but becomes soluble in an aqueous alkali solution under the action of an acid (hereinafter simply referred to as a "phenolic acid-decomposable resin"), is being effectively used.

With respect to the positive resist for use with electron beam, X-ray or EUV, there have been disclosed resist compositions using, for example, a phenol-based compound derivative having a specific structure (see, for example, JP-A-10-83073 (the term "JP-A" as used herein means an "unexamined published Japanese patent application"), JP-A-2000-305270 and JP-A-2003-183227), a calixarene having a specific structure (see, for example, JP-A-10-120610 and JP-A-11-322656), a calixresorcinarene (see, for example, JP-A-11-322656 and JP-A-2003-321423), or a phenol-based dendrimer with the mother nucleus being a calixresorcinarene (see, for example, JP-A-10-310545).

US-B-6 197 473 discloses a positive resist composition comprising (A) a cyclotricatechilene wherein part of the hydroxyl groups have undergone substitution with t-butoxycarbonyl groups and (B) triphenylsulfonium triflate.

EP-A-1 703 326 which is a prior art document according to Article 54(3) EPC, discloses a positive resist composition comprising (A) a dissolution inhibitor having acid - decomposable groups, aromatic rings and alkylene chains and having a molecular weight of 2,000 or less, of which solubility in an alkali developer increases under an action of an acid; and (B) a bridged triphenylsulfonium compound which generates an acid upon irradiation with actinic rays or radiation.

However, it is not achieved at present by any combination of these techniques to satisfy, in the ultrafine region, high sensitivity, high resolution, good pattern profile, good line edge roughness and reduction of outgassing at the same time.

SUMMARY OF THE INVENTION

An object of the present invention is to solve the problem by implementing performance enhancing technology in the fine process of a semiconductor device, where high energy ray, X-ray, electron beam or EUV light is used, and provide a positive resist composition capable of satisfying all of high sensitivity, high resolution, good pattern profile, good line edge roughness and reduction of outgassing, and a pattern forming method using the composition.

As a result of intensive investigations, the present inventors have found that the above-described object can be attained by a positive resist composition comprising a specific compound of which solubility in an alkali developer increases under the action of an acid, and a specific compound capable of generating an acid upon irradiation with actinic rays or radiation. The present invention has been accomplished based on this finding. The present invention has the following constitutions.

(1) A positive resist composition comprising:

(A) a compound having at least two acid-decomposable groups, an aromatic ring and an alkylene or cycloalkylene chain and having a molecular weight of 2,000 or less, of which solubility in an alkali developer increases under the action of an acid, wherein the content of the component (A) is from 65 to 95 mass% based on the solid content of the positive resist composition, and

(B) a compound represented by the following formula (B-1), which generates an acid upon irradiation with actinic rays or radiation:

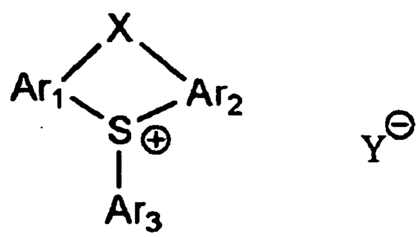

(B-I)

wherein $Ar_1$ to $Ar_3$ each independently represents an aromatic ring having a carbon number of 6 to 20, which may be a substituted or unsubstituted one, provided that at least one of $Ar_1$ to $Ar_3$ has a -Q-$SO_2$Ra group or a -Q-CORb group as the substituent (wherein Ra and Rb each independently represents an alkyl group or an aryl group, Q represents an oxygen atom or -N(Ry)-, and Ry represents a hydrogen atom, an alkyl group or a cycloalkyl group), and Ra, Rb, and Ry may be substituted or unsubstituted

X represents a single bond or a divalent linking group, and

Y represents a sulfonate anion, a carboxylate anion, a bis(alkylsulfonyl)amide anion or a tris(alkylsulfonyl)-methide anion.

(2) The positive resist composition as described in (1), wherein $Ar_3$ in formula (B-1) has a -Q-$SO_2$Ra group or a -Q-CORb group.

(3) The positive resist composition as described in (1) or (2), which further comprises (R1) a resin of which solubility in an alkali developer increases under the action of an acid.

(4) The positive resist composition as described in any one of (1) to (3), which further comprises (R2) a resin having solubility in an alkali developer.

(5) The positive resist composition as described in any one of (1) to (4), wherein the compound as the component (A), of which solubility in an alkali developer increases under the action of an acid, is a compound having a calixarene structure.

(6) A pattern forming method comprising steps of forming a resist film from the positive resist composition described in any one of (1) to (5), and exposing and developing the resist film.

According to the present invention, a positive resist composition capable of satisfying all of high sensitivity, high resolution, good pattern profile, good line edge roughness and reduction of outgassing in the fine processing of a semiconductor device, where high energy ray, X-ray, electron beam or EUV light is used, and a pattern forming method using the composition are provided.

DETAILED DESCRIPTION OF THE INVENTION

The present invention is described in detail below.

The positive resist composition of the present invention comprises (A) a specific compound of which solubility in an alkali developer increases under the action of an acid, and (B) a specific compound capable of generating an acid upon irradiation with actinic rays or radiation.

[1] (A) Compound of which solubility in an alkali developer increases under the action of an acid

The (A) compound of which solubility in an alkali developer increases under the action of an acid, for use in the present invention, is a compound having at least two acid-decomposable groups, an aromatic ring and an alkylene chain or a cycloalkylene chain and having a molecular weight of 2,000 or less. In particular, a compound having a moiety formed by the linking of aromatic ring-alkylene ring-aromatic ring is preferred.

The compound as the component (A), of which solubility in an alkali developer increases under the action of an acid, is not a polymer. The compound is, for example, a compound where the hydroxyl group of a mother nucleus compound having a single molecular skeleton is protected by an acid-decomposable group or the like. Also, this is a compound characterized in that the number of repeating units derived from a polymerizable monomer is less than 10.

The compound as the component (A) has at least two acid-decomposable groups.

The acid-decomposable group is a substituent replacing the hydrogen atom of OH in an alkali-soluble group and is preferably - $C(R_{11a})(R_{12a})(R_{13a})$, $-C(R_{14a})(R_{15a})(OR_{16a})$ or $-CO-OC(R_{11a})(R_{12a})(R_{13a})$. Here, $R_{11a}$ to $R_{13a}$ each independently represents an alkyl group, a cycloalkyl group, an alkenyl group, an aralkyl group or an aryl group, $R_{14a}$ and $R_{15a}$ each independently represents a hydrogen atom or an alkyl group, and $R_{16a}$ represents an alkyl group, a cycloalkyl group, an alkenyl group, an aralkyl group or an aryl group, provided that two members out of $R_{11a}$, $R_{12a}$ and $R_{13a}$ or two members out of $R_{14a}$, $R_{15a}$ and $R_{16a}$ may combine to form a ring.

The compound as the component (A) may be synthesized, for example, by protecting the hydroxyl group of a compound working out to a mother nucleus, with an acid-decomposable group.

Specific preferred examples of the acid-decomposable group are set forth below, but the present invention is not limited thereto.

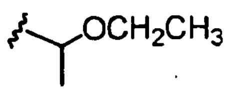
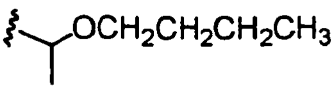
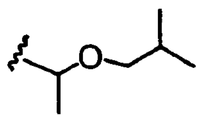

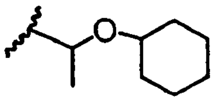
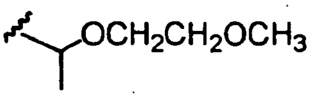
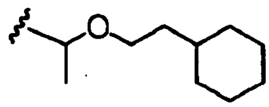

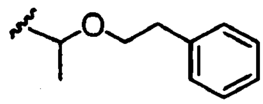
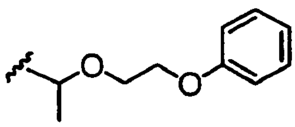
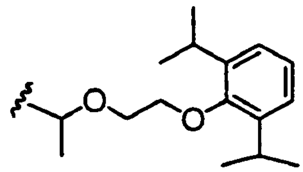

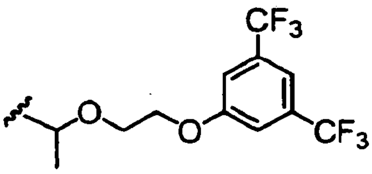
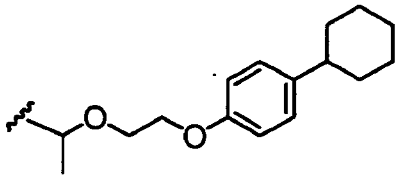

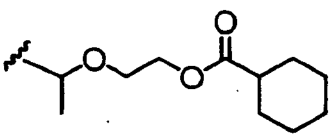
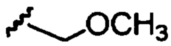
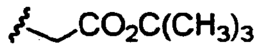

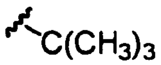
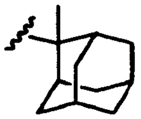
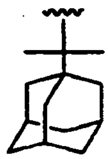
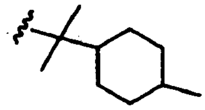

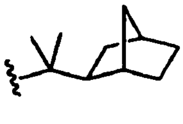
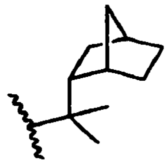
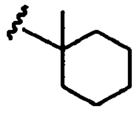
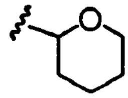

The compound as the component (A) of the present invention is preferably a compound represented by the following formula (I):

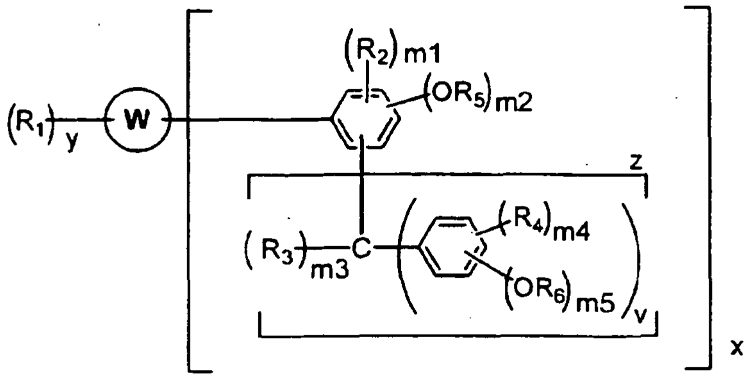

(I)

In formula (I), $R_1$, $R_2$, $R_3$ and $R_4$ each represents a hydrogen atom, an alkyl group or a cycloalkyl group. A plurality of $R_1$'s may combine to form a ring. Also, the plurality of $R_1$'s, $R_2$'s, $R_3$'s or $R_4$'s may be the same or different.

$R_5$ and $R_6$ each represents a hydrogen atom or an organic group, and the plurality of $R_5$'s or $R_6$'s may be the same or different. At least two members out of the plurality of $R_5$'s or $R_6$'s are an acid-decomposable group.

W represents a single bond, an alkylene group, a cycloalkylene group or an arylene group.

x represents a positive integer.

y represents an integer of 0 or more and when W is a single bond, y is 0 and x is 2.

z represents an integer of 0 or more.

v represents an integer of 0 or more.

m1, m3 and m4 each represents a positive integer.

m2 and m5 each represents an integer of 0 or more. However, the relationships of $m1+m2+z=5$, $m3+v=3$, $m4+m5=5$ and $m2+m5\geq 2$ are satisfied.

The alkyl group in $R_1$, $R_2$, $R_3$ and $R_4$ may be linear or branched and is preferably an alkyl group having a carbon number of 1 to 10, such as methyl group, ethyl group, a propyl group, a butyl group, an isobutyl group, a hexyl group and an octyl group.

The cycloalkyl group in $R_1$, $R_2$, $R_3$ and $R_4$ may be monocyclic or polycyclic and, for example, includes a group having a carbon number of 5 or more and having a monocyclo, bicyclo, tricyclo or tetracyclo structure. The carbon number thereof is preferably from 6 to 30, more preferably from 7 to 25, and examples thereof include an adamantyl group, a noradamantyl group, a decalin residue, a tricyclodecanyl group, a tetracyclododecanyl group, a norbornyl group, a cedrol group, a cyclohexyl group, a cycloheptyl group, a cyclooctyl group, a cyclodecanyl group and a cyclododecanyl group. These alicyclic hydrocarbon groups each may have a substituent.

Examples of the substituent which these alkyl group and cycloalkyl group may have include a hydroxyl group, a carboxyl group, a halogen atom (e.g., fluorine, chlorine, bromine, iodine) and an alkoxy group (e.g., methoxy, ethoxy, propoxy, butoxy).

The organic group in $R_5$ and $R_6$ is an acid-decomposable or non-acid-decomposable group. In the present invention, the compound contains from 2 to 30 acid-decomposable groups within one molecule. The number of acid-decomposable groups contained within one molecule is preferably from 3 to 25, more preferably from 4 to 20.

The non-acid-decomposable organic group in $R_5$ and $R_6$ is an organic group incapable of decomposing under the action of an acid, and examples thereof include an alkyl group, a cycloalkyl group, an aryl group, an aralkyl group, an alkoxy group, an alkoxycarbonyl group, an amide group and a cyano group, which are incapable of decomposing under the action of an acid. The alkyl group is preferably an alkyl group having a carbon number of 1 to 10, and examples thereof include a methyl group, an ethyl group, a propyl group, an n-butyl group, a sec-butyl group, a hexyl group, a 2-ethylhexyl group and an octyl group. The cycloalkyl group is preferably a cycloalkyl group having a carbon number of 3 to 10, and examples thereof include a cyclopropyl group, a cyclobutyl group, a cyclohexyl group and an adamantyl group. The aryl group is preferably an aryl group having a carbon number of 6 to 14, and examples thereof include a phenyl group, a naphthyl group and an anthracenyl group. The aralkyl group is preferably an aralkyl group having a carbon number of 6 to 12, and examples thereof include a benzyl group, a phenethyl group and a cumyl group. The alkoxy group and the alkoxy group in the alkoxycarbonyl group are preferably an alkoxy group having a carbon number of 1 to 5, and examples thereof include a methoxy group, an ethoxy group, a propoxy group, an n-butoxy group and an isobutoxy group.

The alkylene group in W may be linear or branched and is preferably an alkylene group having a carbon number of 1 to 10, and examples thereof include a methylene group, an ethylene group, a propylene group, a butylene group and an isobutylene group.

The cycloalkylene group in W may be monocyclic or polycyclic, and the alkylene group forming the ring includes, for example, a cycloalkylene group having a carbon number of 3 to 8 (e.g., cyclopentylene, cyclohexylene).

The above-described groups each may further have a substituent, and examples of the substituent include an alkyl group (preferably having a carbon number of 1 to 10, such as methyl group, ethyl group, propyl group, isopropyl group, n-butyl group, isobutyl group, sec-butyl group, tert-butyl group, pentyl group, hexyl group, heptyl group, octyl group, nonyl group and decyl group), an alkoxy group (preferably having a carbon number of 1 to 4, such as methoxy group, ethoxy group, propoxy group and butoxy group), a fluorine atom, a chlorine atom, a bromine atom and an iodine atom.

The alkylene chain or cycloalkylene chain may contain, in the alkylene chain, -O-, -OC(=O)-, -OC(=O)O-, -N(R)-C(=O)-, -N(R)-C(=O)O-, -S-, -SO- or $-SO_2-$. Here, R is a hydrogen atom or an alkyl group (preferably having a carbon number of 1 to 10, such as methyl group, ethyl group, propyl group, isopropyl group, n-butyl group, isobutyl group, sec-butyl group, tert-butyl group, pentyl group, hexyl group, heptyl group, octyl group, nonyl group and decyl group).

The cyclic arylene group in W is preferably a cyclic arylene group having a carbon number of 6 to 15, such as phenylene group, tolylene group and naphthylene group.

The compound represented by formula (I) is preferably a compound represented by any one of the following formulae (II) to (IV):

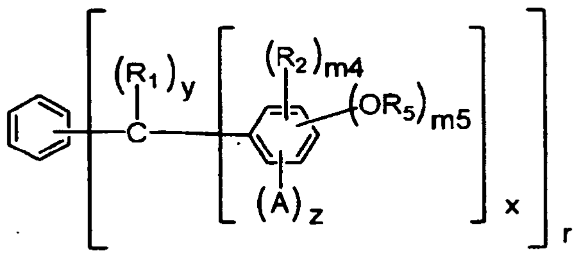

(II)

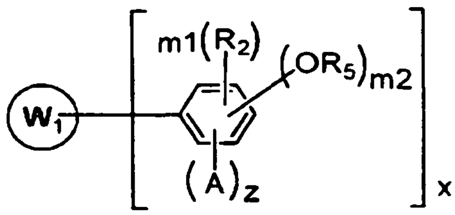

(III)

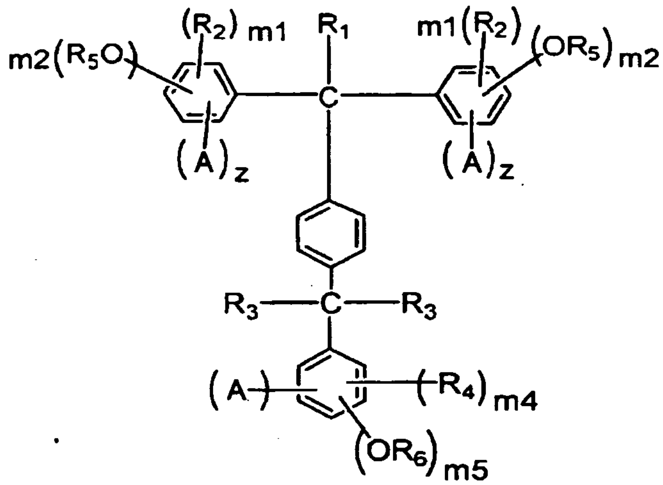

(IV)

In formulae (II) to (IV), $R_1$, $R_2$, $R_3$, $R_4$, $R_5$, $R_6$, x, y, z, m1, m2, m4 and m5 have the same meanings as those in formula (I).

$W_1$ represents a single bond, an alkylene group or a cycloalkylene group. Here, the alkylene group and cycloalkylene group have the same meanings as those in W above.

A represents the following structure:

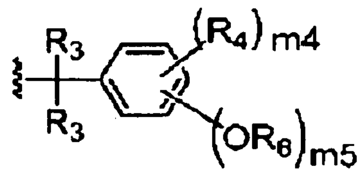

wherein $R_3$, $R_4$, $R_6$, m4 and m5 have the same meanings as those in formula (I).

Specific examples of the mother nucleus compound of the compound represented by formula (I) are set forth below, but the present invention is not limited thereto.

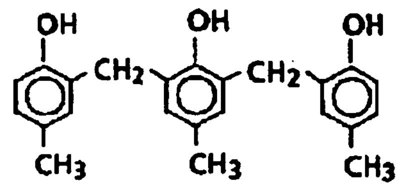

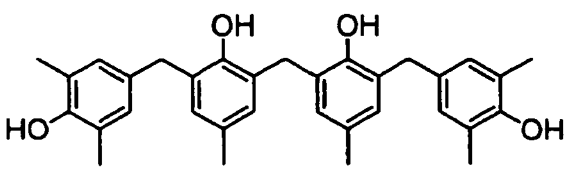

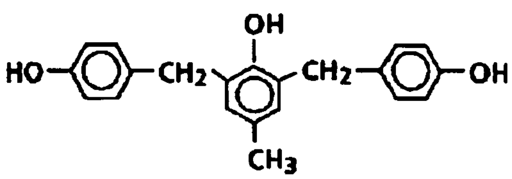

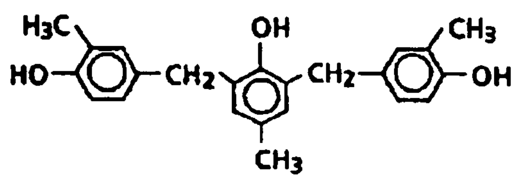

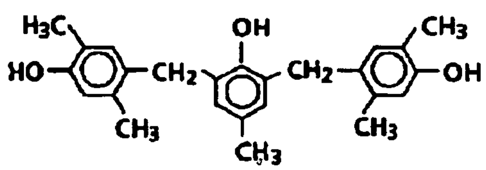

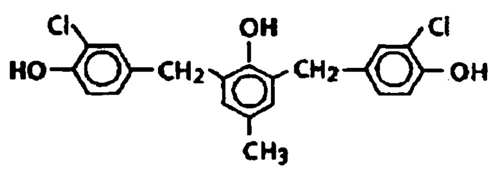

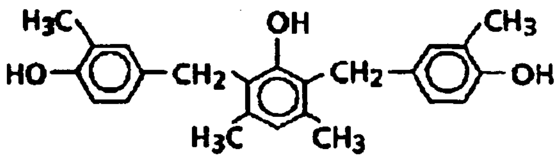

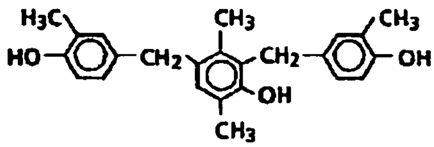

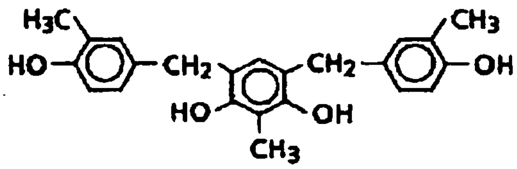

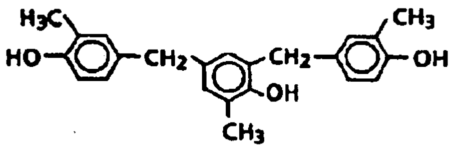

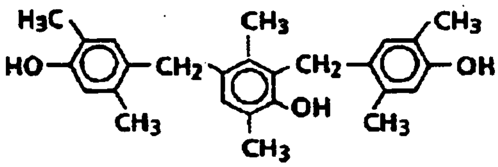

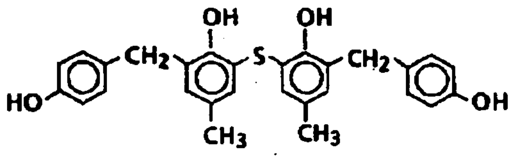

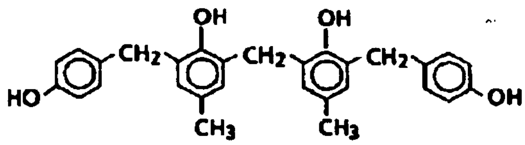

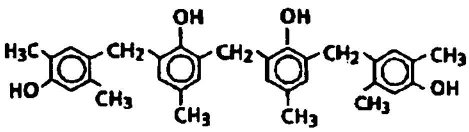

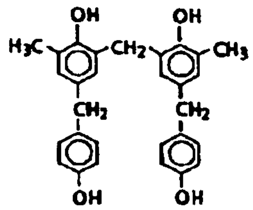

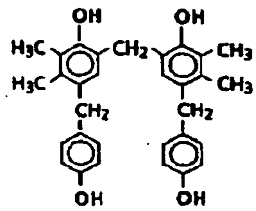

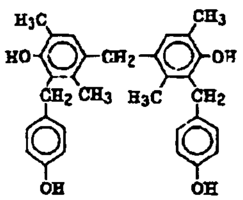

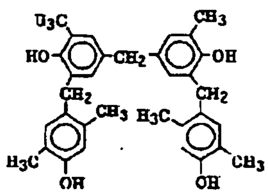

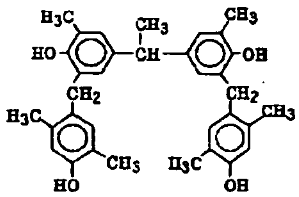

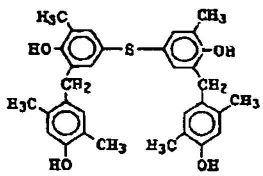

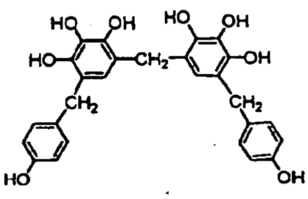

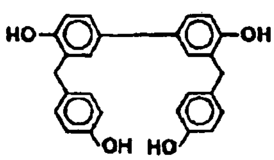

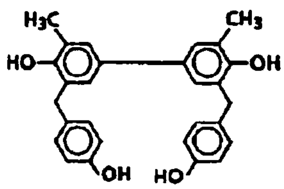

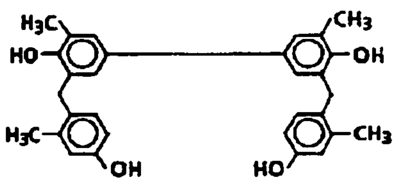

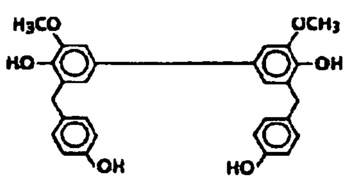

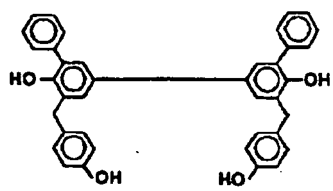

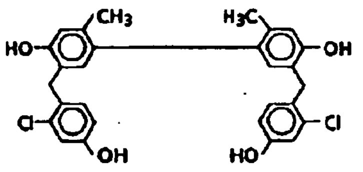

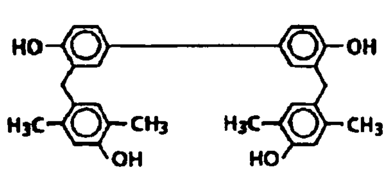

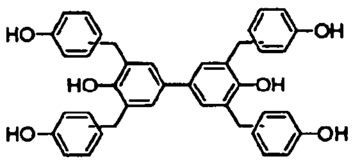

A mixture of ortho-substitution/para-substitution

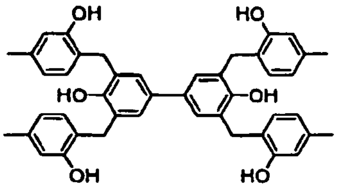

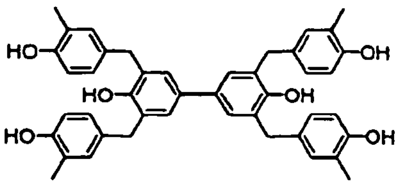

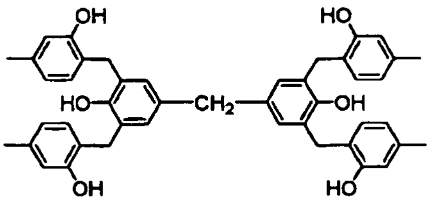

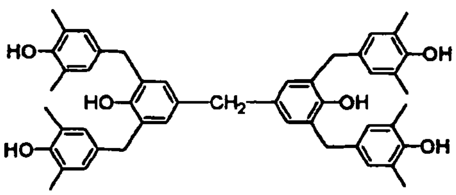

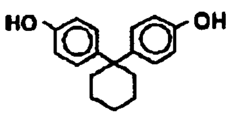

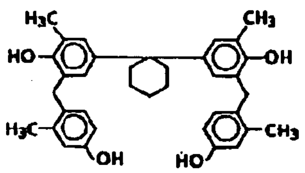

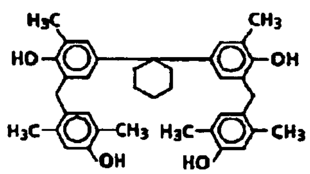

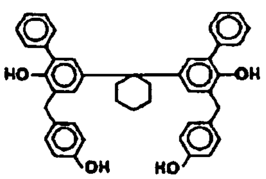

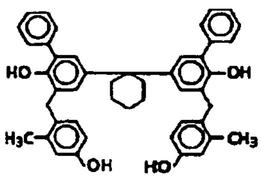

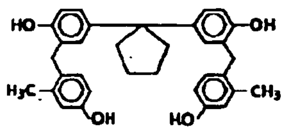

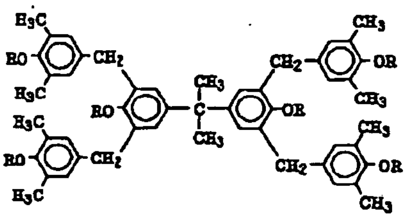

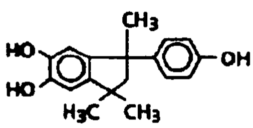

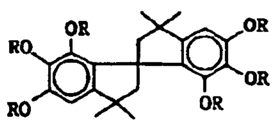

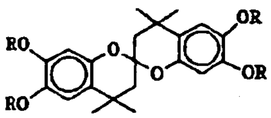

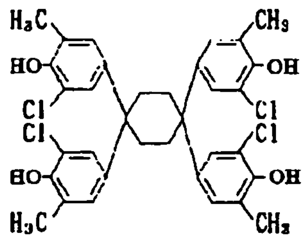
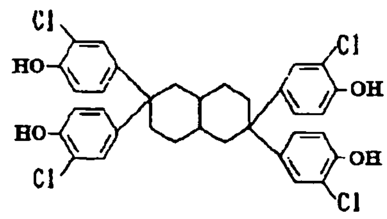
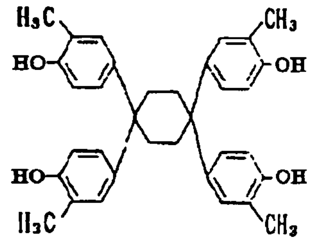
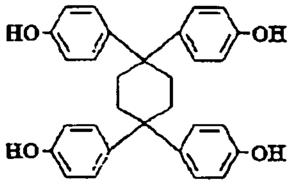
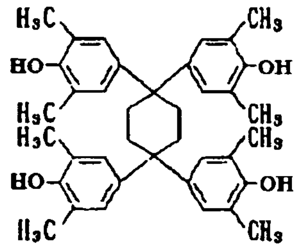
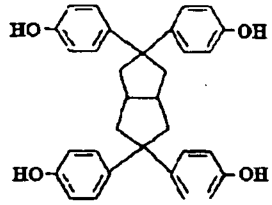
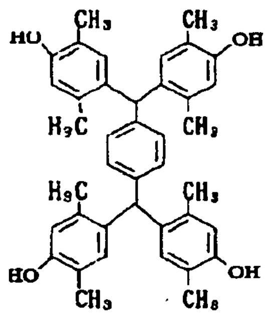
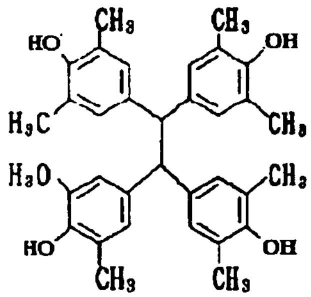
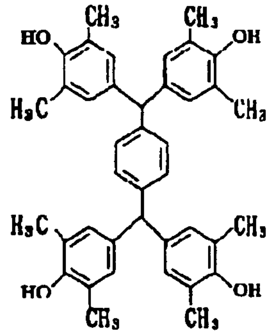
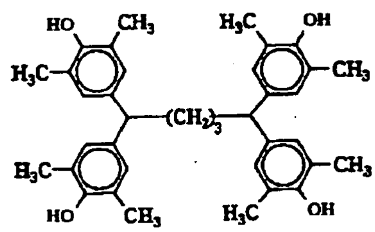
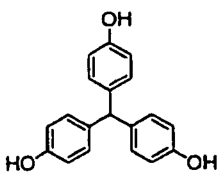
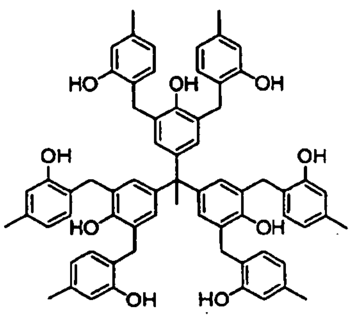
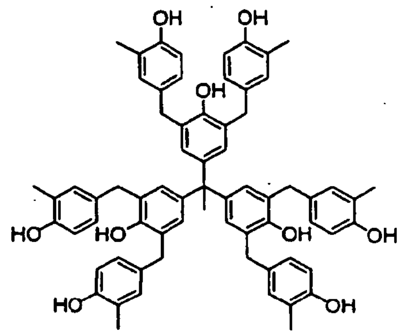

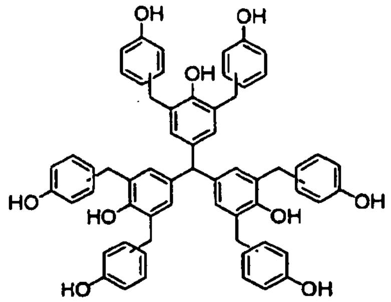

A mixture of ortho-substitution
/para-substitution

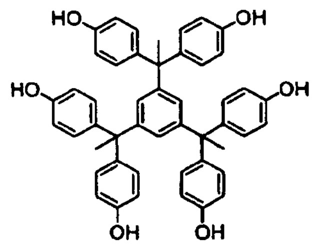

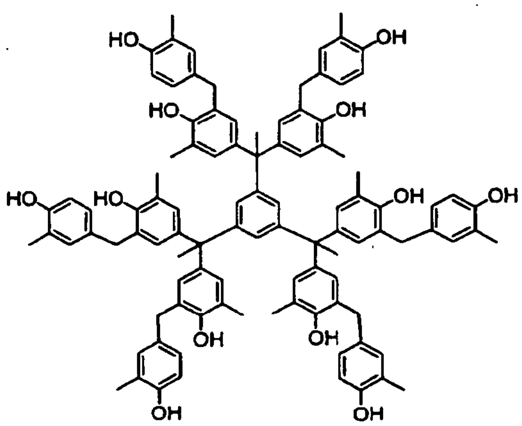

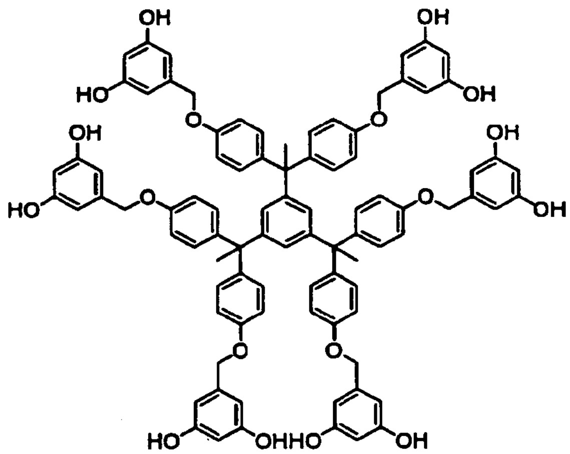

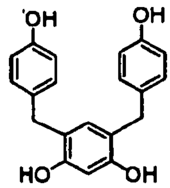

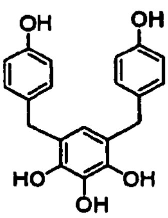

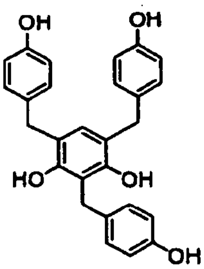

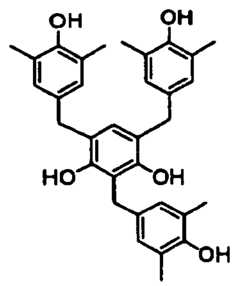

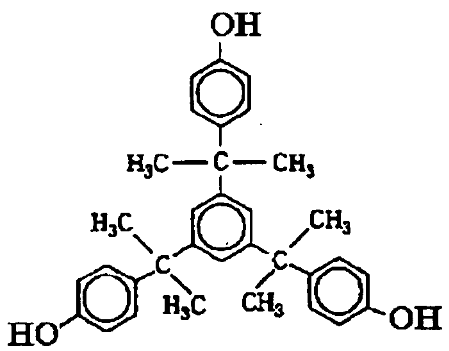

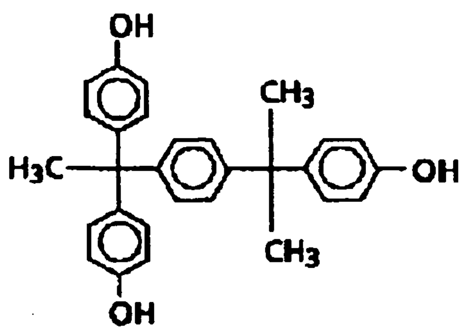

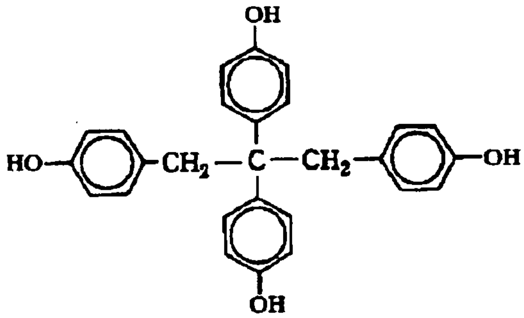

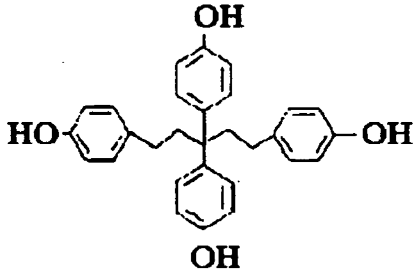

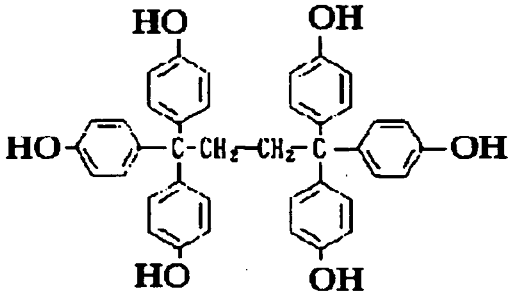

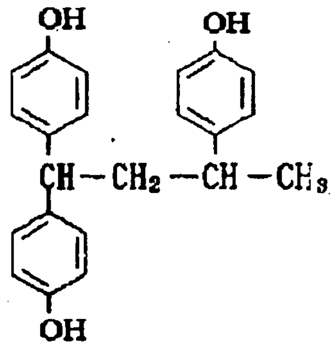

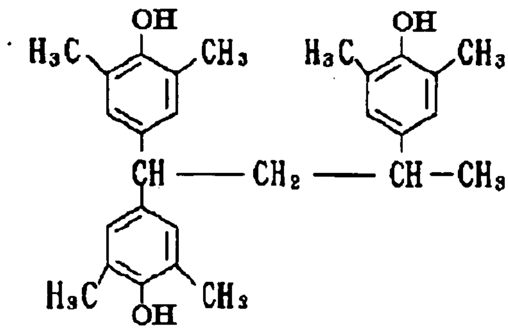

The compound as the component (A) of the present invention is more preferably a compound represented by the following formula (V):

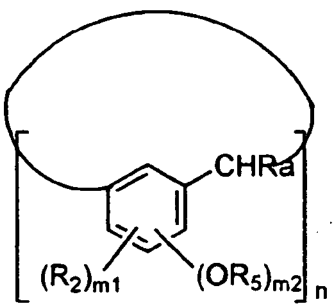

(V)

In formula (V), $R_2$, $R_5$, m1 and m2 have the same meanings as $R_2$, $R_5$, m1 and m2 in formula (I).

Ra represents a hydrogen atom or an alkyl group (preferably having a carbon number of 1 to 15).

n represents an integer of 3 to 8.

Examples of the mother nucleus compound of the compound represented by formula (V) include those having a calixarene structure shown below.

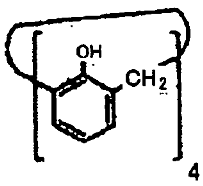

(C-1)

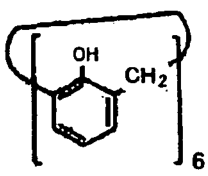

(C-2)

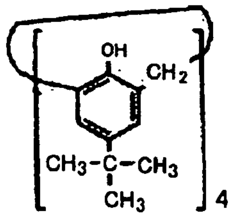

(C-3)

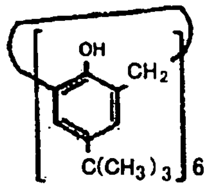

(C-4)

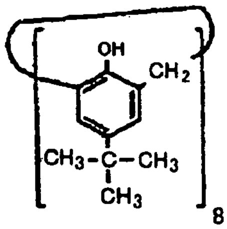

(C-5)

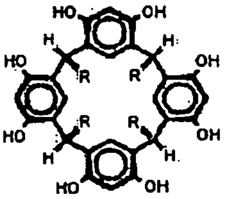

R=$CH_3$

(C-6)

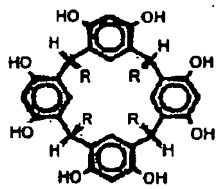

R= $-CH_2(CH_2)_9CH_3$

(C-7)

The (A) compound having at least two acid-decomposable groups within one molecule, of which solubility in an alkali developer increases under the action of an acid, for use in the present invention preferably has an alkali-soluble group.

Examples of the alkali-soluble group include a hydroxyl group, a sulfonic acid group, a phenol group, a carboxylic acid group and a hexafluoroisopropanol group [$-C(CF_3)_2OH$]. Among these, a phenol group, a carboxyl group and a hexafluoroisopropanol group are preferred, and a phenol group and a carboxyl group are more preferred.

The molecular weight of the compound working out to the mother nucleus in the compound as the component (A) is usually from 200 to 2,000, preferably from 300 to 2,000, more preferably from 400 to 2,000. The compound working out to the mother nucleus in the compound as the component (A) is commercially available, for example, from Honshu Kagaku, and such a commercial product may also be used. Also, the compound may be synthesized by the condensation of various phenol compounds with various aldehydes or ketones.

The content of the component (A) is from 65 to 95 mass%, preferably from 70 to 90 mass%, more preferably from 75 to 85 mass%, based on the solid content of the positive resist composition.

In the positive resist composition of the present invention, a resin (polymer) may be further added. The resin added is a resin (not containing an acid-decomposable group) having solubility in an alkali developer (alkali-soluble resin (R2)) or a resin of which solubility in an alkali developer increases under the action or an acid (acid-decomposable resin (R1)). The alkali-soluble resin (R2) includes a homopolymer or copolymer of p-hydroxystyrene, a homopolymer or copolymer of (meth)acrylic acid, and a homopolymer or copolymer of p-(1,1,1,3,3,3-hexafluoro-2-hydroxypropyl)styrene. The acid-decomposable resin (R1) includes a resin obtained by protecting the above-described alkali-soluble resin with an acid-decomposable group.

The content of the resin added is usually from 1 to 50 mass%, preferably from 5 to 40 mass%, more preferably from 10 to 30 mass%, based on the entire solid content of the positive resist composition.

[2] Compound represented by formula (B-1), which generates an acid upon irradiation with actinic rays or radiation

The positive resist composition of the present invention contains a compound represented by the following formula (B-I) (hereinafter sometimes simply referred to as a "compound (B)") as the compound capable of generating an acid upon irradiation with actinic rays or radiation.

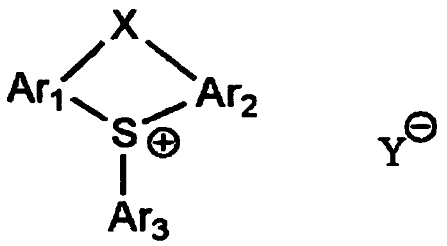

(B-I)

In formula (B-1), $Ar_1$ to $Ar_3$ each independently represents an aromatic ring having a carbon number of 6 to 20, which may be a substituted or unsubstituted one, provided that at least one of $Ar_1$ to $Ar_3$ has a -Q-$SO_2$Ra group or a -Q-CORb group as the substituent (wherein Ra and Rb each independently represents an alkyl group or an aryl group, Q represents an oxygen atom or -N(Ry)-, Ry represents a hydrogen atom, an alkyl group or a cycloalkyl group, and Ra, Rb, and Ry may be substituted or unsubstituted).

X represents a single bond or a divalent linking group.

Y represents a sulfonate anion, a carboxylate anion, a bis(alkylsulfonyl)amide anion or a tris(alkylsulfonyl)-methide anion.

The aromatic ring of $Ar_1$ to $Ar_3$ in formula (B-1) is preferably a benzene ring or a naphthalene ring. The aromatic ring may have a substituent, and preferred examples of the substituent which the aromatic ring may have include a linear, branched or cyclic alkyl group having a carbon number of 1 to 6, an alkoxy group having a carbon number of 1 to 6, an acyl group having a carbon number of 1 to 6, an aryl group having a carbon number of 6 to 10, a cyano group, a nitro group and a halogen atom.

The alkyl group as Ra, Rb and Ry is preferably a liner or branched alkyl group having a carbon number of 1 to 20, more preferably a linear or branched alkyl group having a carbon number of 1 to 12, and examples thereof include a methyl group, an ethyl group, a propyl group, an isopropyl group, an n-butyl group, an isobutyl group, a sec-butyl group, a tert-butyl group, a pentyl group, a hexyl group, a heptyl group, an octyl group, a nonyl group and a decyl group.

The aryl group as Ra and Rb is preferably an aryl group having a carbon number of 6 to 15, and examples thereof include a phenyl group and a naphthyl group.

The cycloalkyl group as Ry is preferably a cycloalkyl group having a carbon number of 3 to 20, more preferably a cycloalkyl group having a carbon number of 5 to 15, and examples thereof include a cyclopentyl group, a cyclohexyl group, a norbornyl group and an adamantyl group.

The alkyl group, aryl group and cycloalkyl group as Ra, Rb and Ry each may further have a substituent, and the alkyl group and aralkyl group each may contain a heteroatom such as oxygen atom, sulfur atom and nitrogen atom in its alkyl chain. Preferred examples of the substituent include a halogen atom, a hydroxyl group, an alkoxy group (preferably having a carbon number of 1 to 20), a nitro group, a cyano group, an alkoxycarbonyl group (preferably having a carbon number of 1 to 20), and an acyl group (preferably having a carbon number of 1 to 20). In the case of a cyclic structure such as cyclo ring and aromatic ring, examples of the substituent further include an alkyl group (preferably having a carbon number of 1 to 20).

The divalent linking group of X includes an oxygen atom, a sulfur atom, a single bond and an alkylene group. The alkylene group may have a substituent, and examples of the substituent include a hydroxyl group, an alkoxy group, an acyl group, a halogen atom, a cyano group and a nitro group.

X is preferably a single bond, an oxygen atom or an alkylene group having a carbon number of 1 to 3.

The anion of Y in formula (B-I) may be monovalent or may be divalent or higher valent. In the case of a divalent or higher valent anion, the compound (B) may have two or more cations represented by formula (B-I).

Y in formula (B-I) is preferably an organic anion represented by any one of the following formulae (Y1) to (Y4).

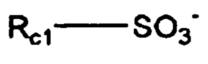

(Y1)

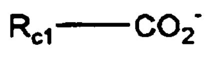

(Y2)

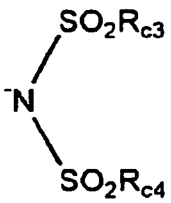

(Y3)

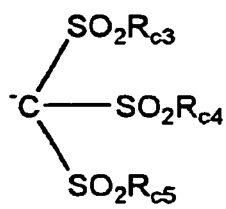

(Y4)

In formulae (Y1) to (Y4), $R_{c1}$ represents an organic group.

The organic group of $R_{c1}$ is preferably an organic group having a carbon number of 1 to 30, more preferably

an alkyl group, a cycloalkyl group, an aryl group or a group where a plurality of these groups are connected through a single bond or a linking group such as -O-, $-CO_2-$, -S-, $-SO_3-$ and $-SO_2N(R_{d1})-$. $R_{d1}$ represents a hydrogen atom or an alkyl group.

$R_{c3}$, $R_{c4}$ and $R_{c5}$ each independently represents an organic group.

The preferred organic group of $R_{c3}$, $R_{c4}$ and $R_{c5}$ is the same as the preferred organic group of $R_{c1}$, and the organic group is more preferably a perfluoroalkyl group having a carbon number of 1 to 4.

$R_{c3}$ and $R_{c4}$ may combine to form a ring.

The group formed by combining $R_{c3}$ and $R_{c4}$ includes an alkylene group and an arylene group, and a perfluoroalkylene group having a carbon number of 2 to 4 is preferred.

The organic group of $R_{c1}$ and $R_{c3}$ to $R_{c5}$ is particularly preferably an alkyl group with the 1-position being substituted by a fluorine atom or a fluoroalkyl group, or a phenyl group substituted by a fluorine atom or a fluoroalkyl group. By virtue of having a fluoro atom or a fluoroalkyl group, the acidity of the acid generated upon light irradiation increases and the sensitivity is enhanced.

Specific examples of the compound (B) represented by formula (B-I) are set forth below, but the present invention is not limited thereto.

I-1

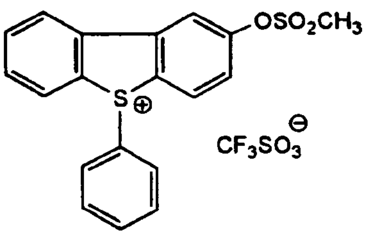

I-2

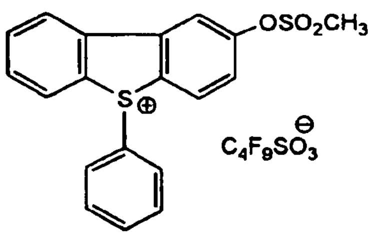

I-3

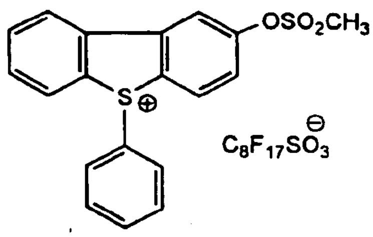

I-4

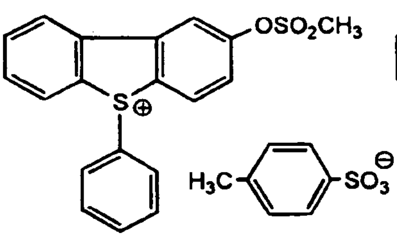

I-5

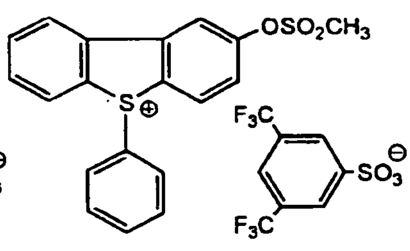

I-6

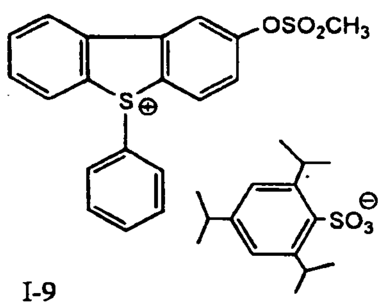

I-7

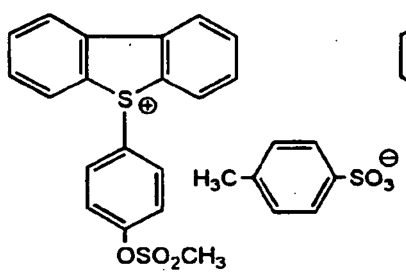

I-8

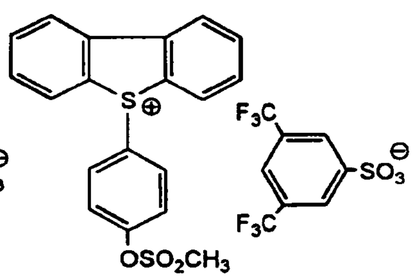

I-9

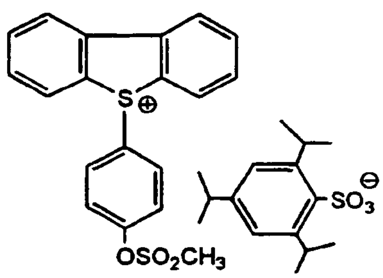

I-10

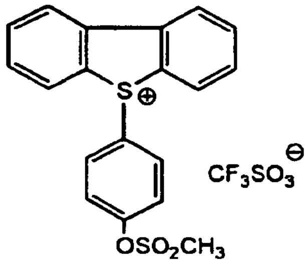

I-11

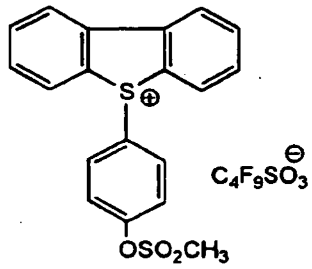

I-12

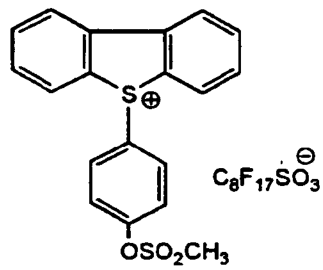

I-13

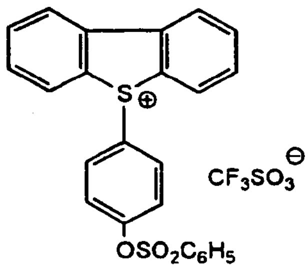

I-14

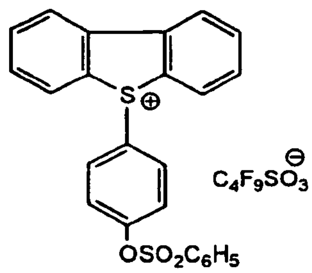

I-15

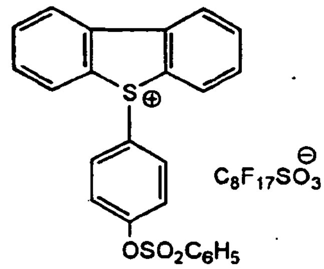

I-16

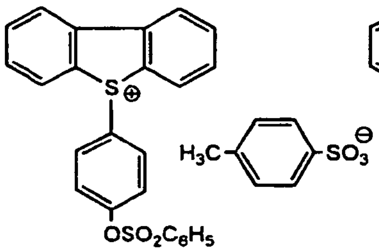

I-17

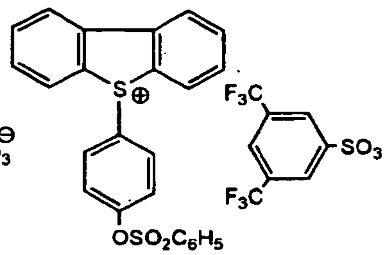

I-18

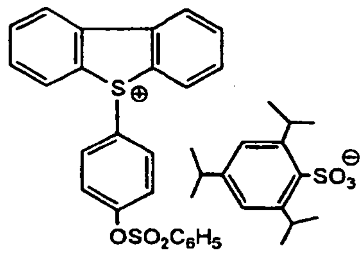

I-19

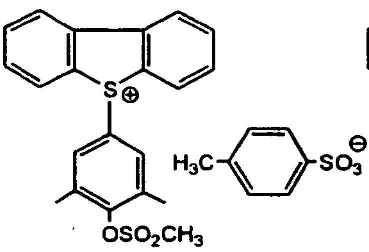

I-20

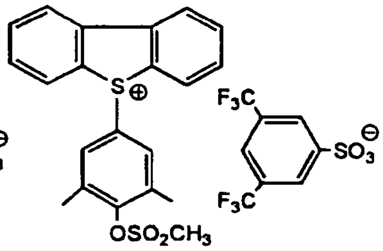

I-21

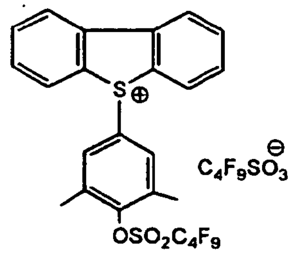

I-22

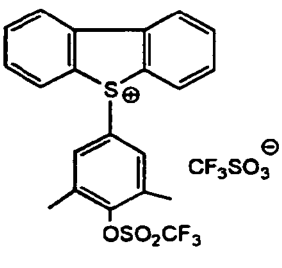

I-23

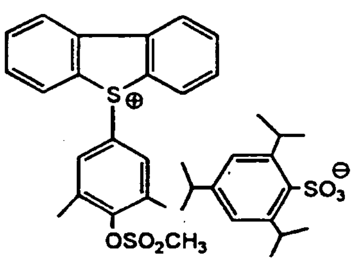

I-24

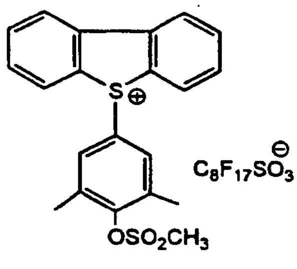

I-25

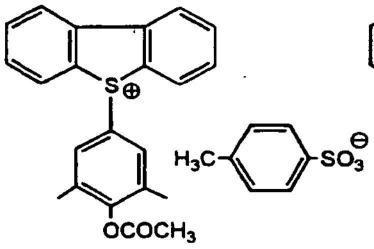

I-26

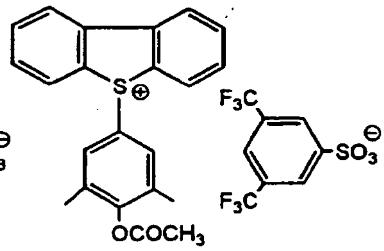

I-27

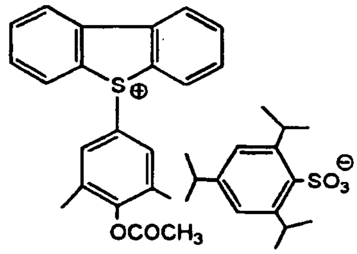

I-28

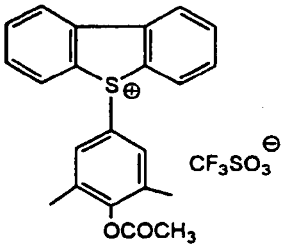

I-29

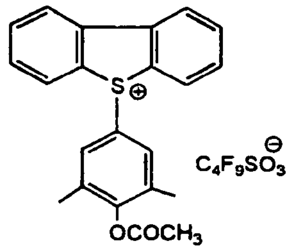

I-30

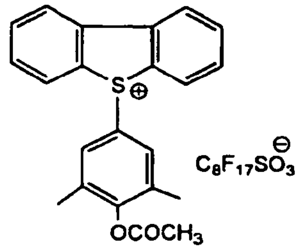

I-31

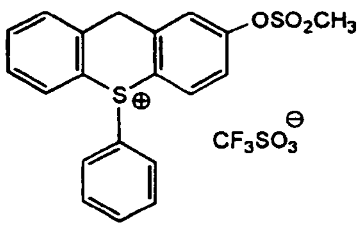

I-32

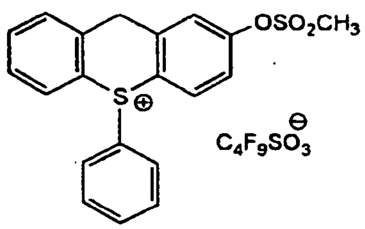

I-33

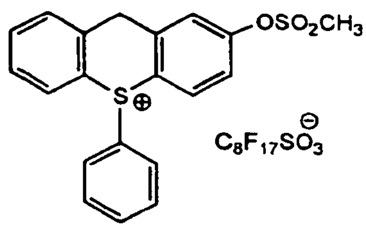

I-34

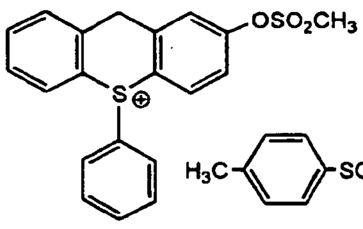

I-35

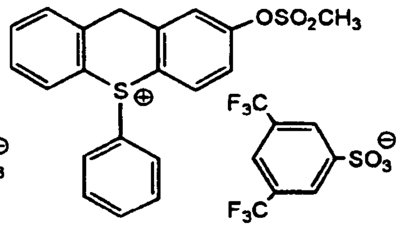

I-36

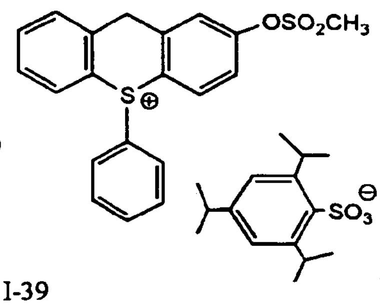

I-37

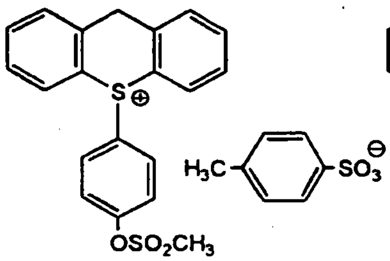

I-38

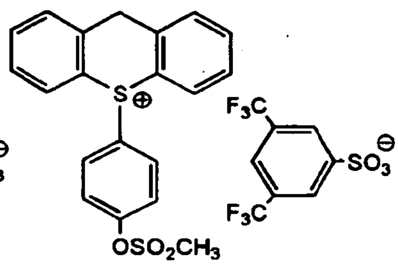

I-39

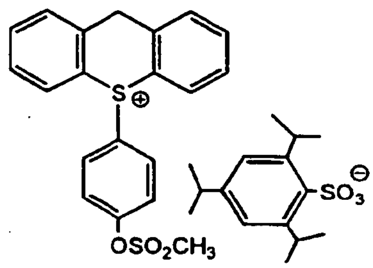

I-40

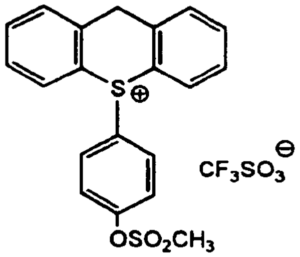

I-41

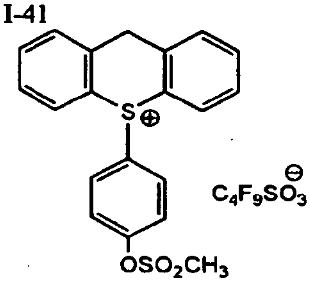

I-42

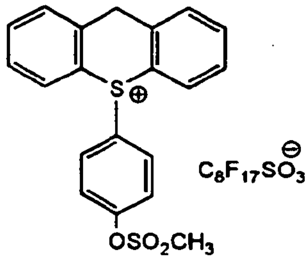

I-43

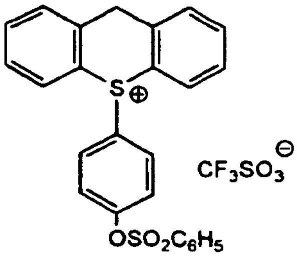

I-44

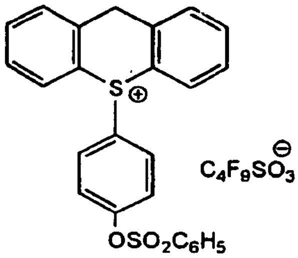

I-45

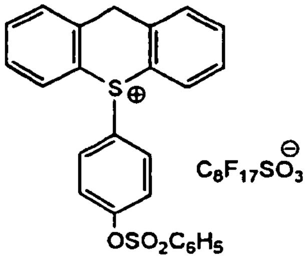

I-46

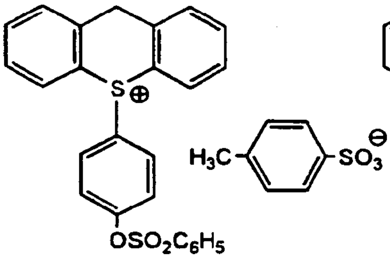

I-47

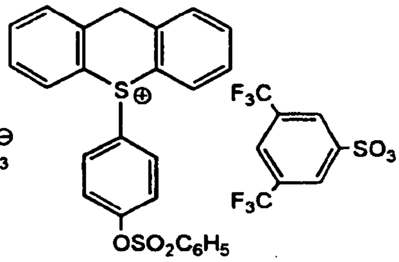

I-48

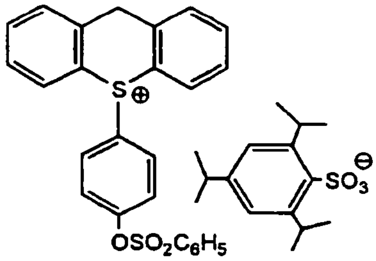

I-49

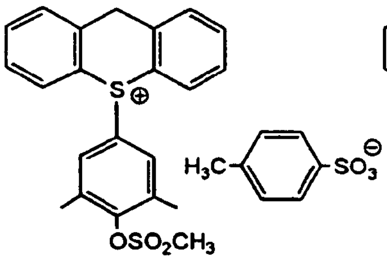

I-50

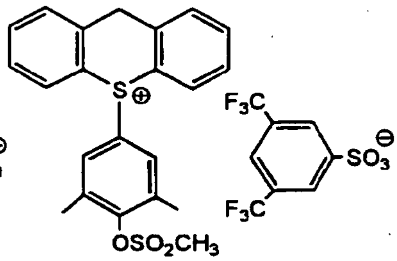

I-51

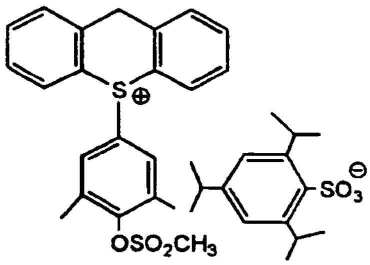

I-52

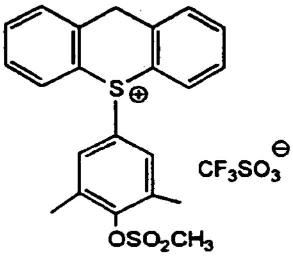

I-53

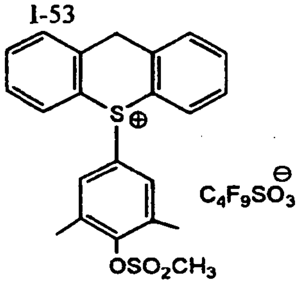

I-54

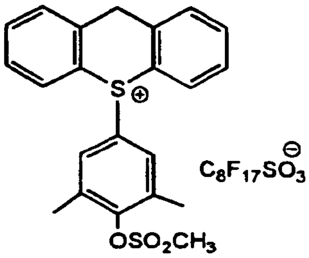

I-55
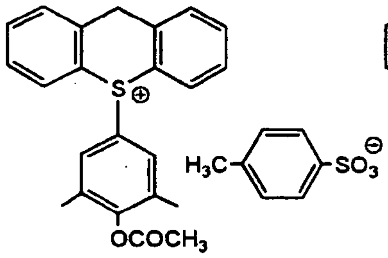

I-56
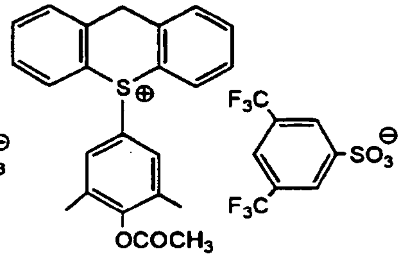

I-57
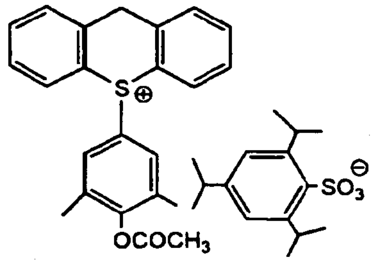

I-58
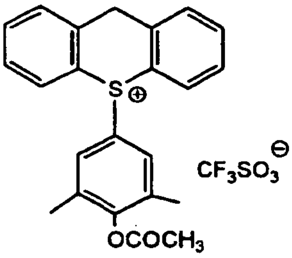

I-59
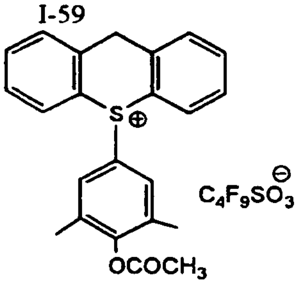

I -60
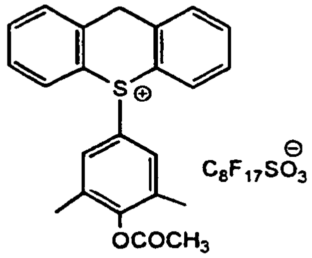

I-61
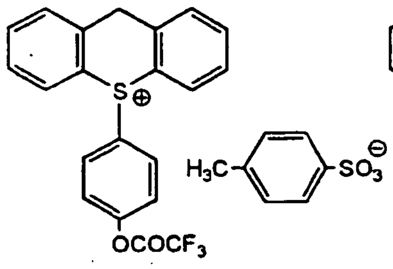

I-62
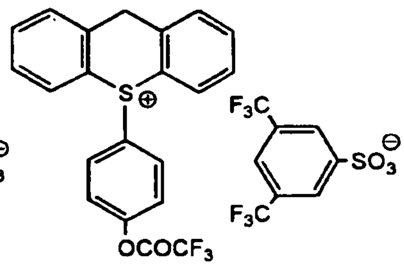

I-63
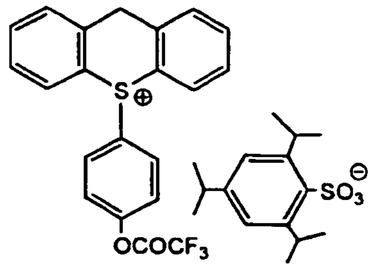

I-64
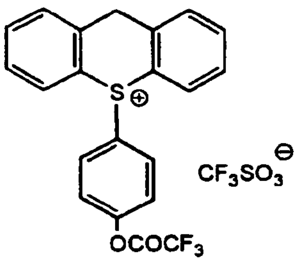

I-65
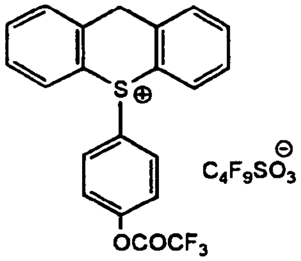

I-66
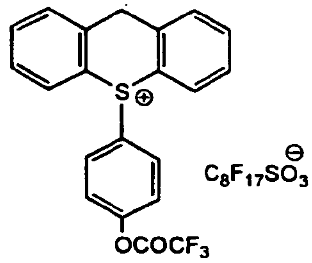

I-67
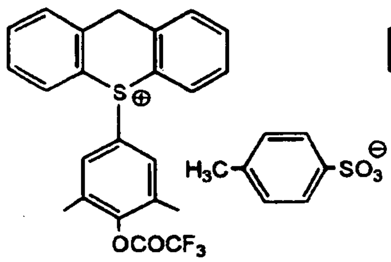

I-68
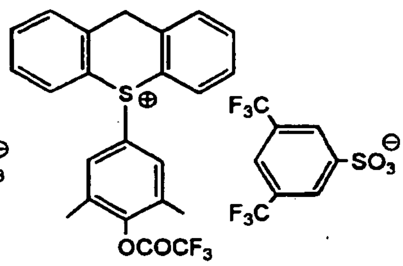

I-69
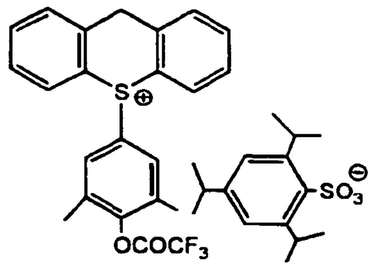

I-70

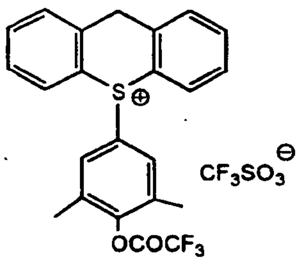

I-71

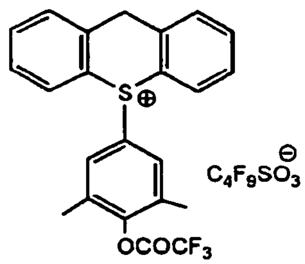

I-72

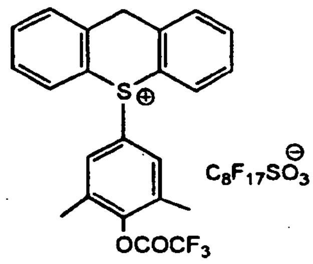

I-73

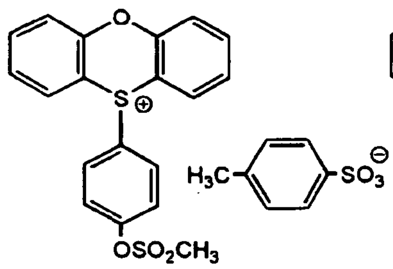

I-74

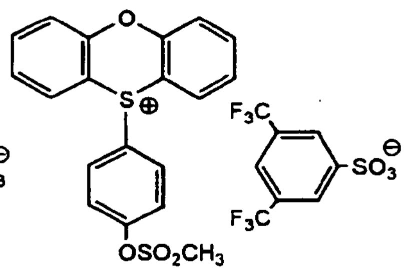

I-75

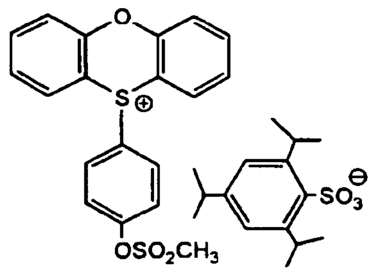

I-76

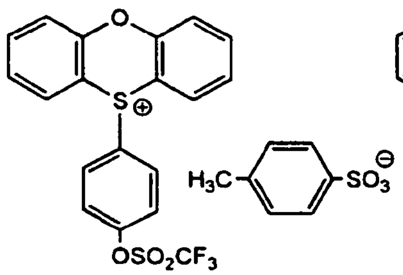

I-77

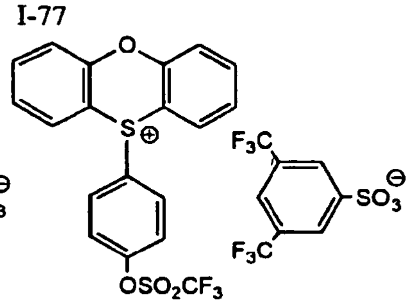

I-78

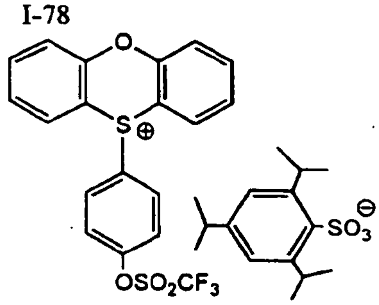

I-79

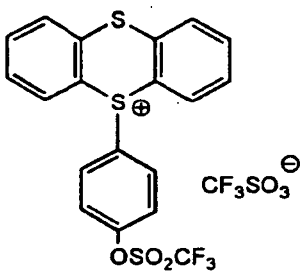

I-80

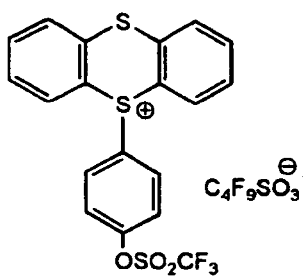

I-81

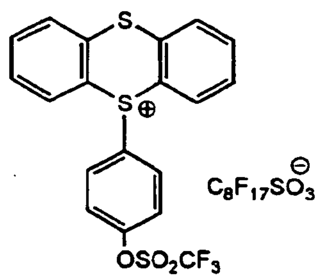

I-82

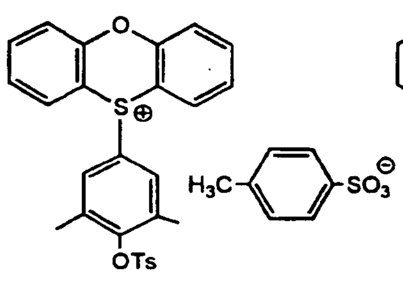

I-83

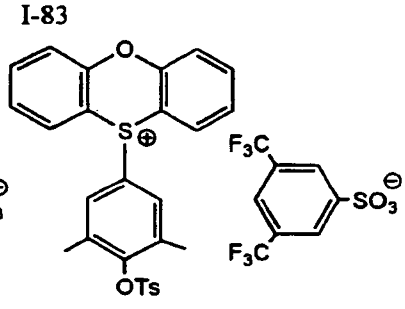

I-84

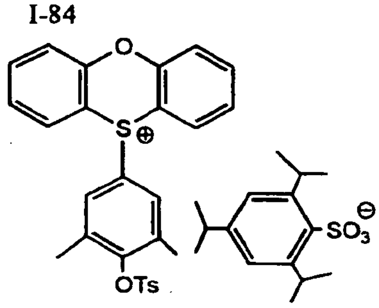

I-85

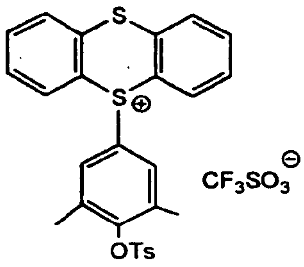

I-86

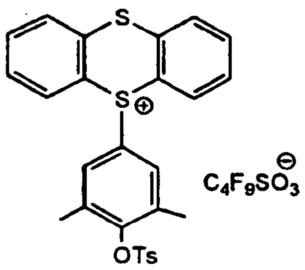

I-87

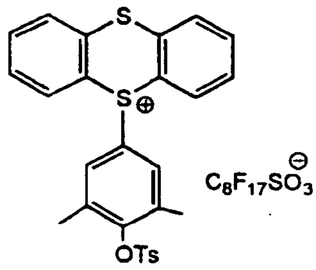

I-88

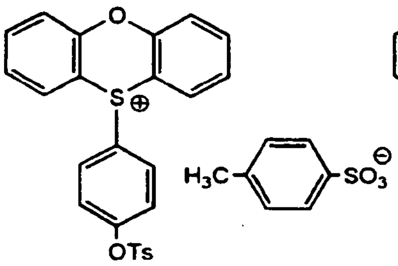

I-89

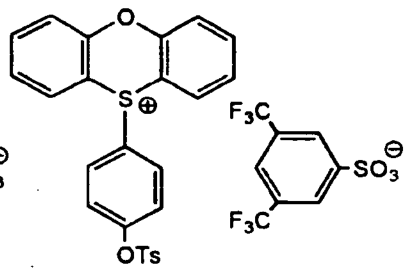

I-90

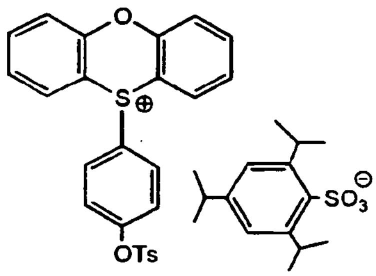

I-91

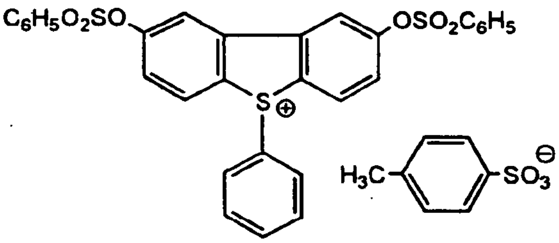

I-92

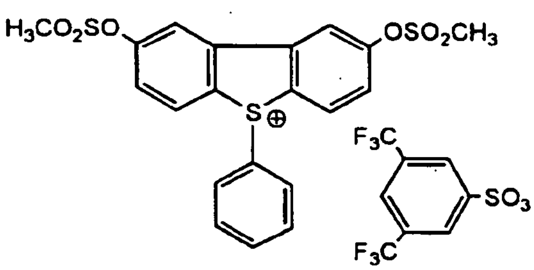

I-93

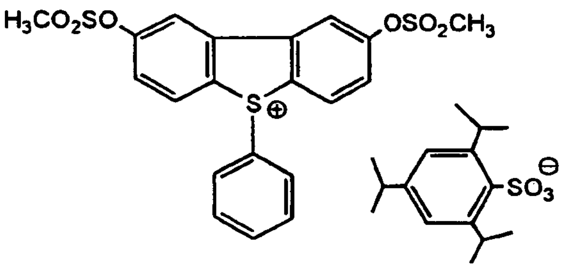

I-94

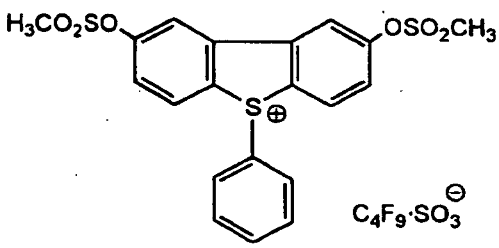

I-95

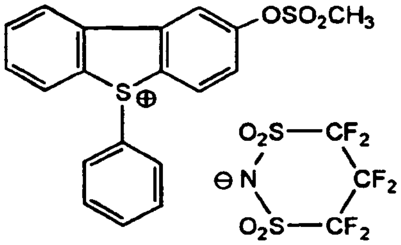

I-96

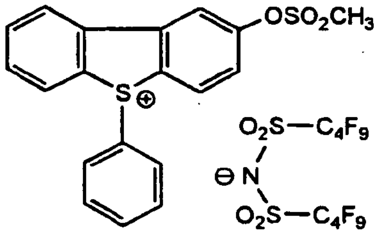

I-97

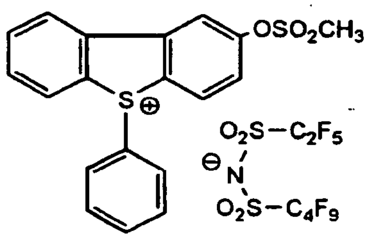

I-98

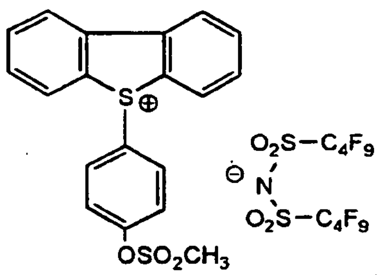

I-99

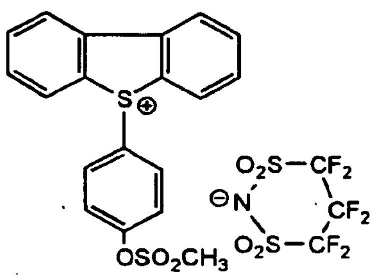

I-100

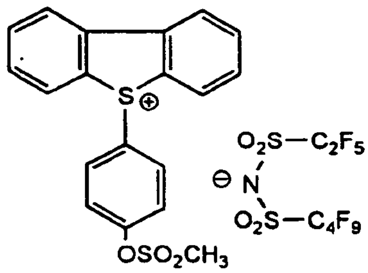

The compound represented by formula (B-I) can be synthesized, for example, by synthesizing a compound having a hydroxyl group or an amino group and then reacting the compound with a commercially available sulfonic acid halide or sulfonic acid anhydride. For example, the compound may be synthesized by reacting a phenol compound or an aniline compound with a compound such as dibenzothiophene sulfoxide in the presence of an acid catalyst (preferably, diphosphorus pentoxide/methanesulfonic acid), reacting the reaction product with a sulfonic acid halide or a sulfonic acid anhydride under basic conditions, and then performing salt exchange with a desired anion.

The content of the compound (B) is preferably from 0.1 to 20 mass%, more preferably from 0.5 to 10 mass%, still more preferably from 1 to 7 mass%, based on the entire solid content of the composition.

(Acid Generator Used in Combination)

In the present invention, other than the compound (B), a compound capable of decomposing upon irradiation with actinic rays or radiation to generate an acid (acid generator) may be further used in combination.

The amount used of the photoacid generator which can be used in combination is, in terms of the molar ratio (compound (B)/another acid generator), usually from 100/0 to 20/80, preferably from 100/0 to 40/60, more preferably from 100/0 to 50/50.

As for the photoacid generator which can be used in combination, a photoinitiator for photocationic polymerization, a photoinitiator for photoradical polymerization, a photo-decoloring agent for coloring matters, a photo-discoloring agent, a known compound capable of generating an acid upon irradiation with actinic rays or radiation, which is used for microresist and the like, or a mixture thereof may be appropriately selected and used.

Examples thereof include a diazonium salt, a phosphonium salt, a sulfonium salt, an iodonium salt, an imidosulfonate, an oxime sulfonate, a diazodisulfone, a disulfone and an o-nitrobenzyl sulfonate.

Also, a compound where the above-described group or compound capable of generating an acid upon irradiation with actinic rays or radiation is introduced into the polymer main or side chain, such as compounds described in U.S. Patent 3,849,137, German Patent 3,914,407, JP-A-63-26653, JP-A-55-164824, JP-A-62-69263, JP-A-63-146038, JP-A-63-163452, JP-A-62-153853 and JP-A-63-146029, may be used.

Furthermore, a compound capable of generating an acid by the effect of light described, for example, in U.S. Patent 3,779,778 and European Patent 126,712 may also be used.

As for the compound capable of decomposing upon irradiation with actinic rays or radiation to generate an acid, which can be used in combination, the compounds represented by the following formulae (ZI), (ZII) and (ZIII) are preferred.

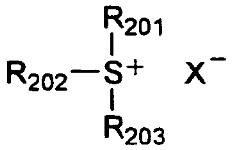

ZI

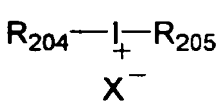

ZII

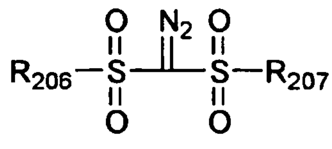

ZIII

In formula (ZI), $R_{201}$, $R_{202}$ and $R_{203}$ each independently represents an organic group.

The carbon number of the organic group as $R_{201}$, $R_{202}$ and $R_{203}$ is generally from 1 to 30, preferably from 1 to 20.

Two members out of $R_{201}$ to $R_{203}$ may combine to form a ring structure, and the ring may contain an oxygen atom, a sulfur atom, an ester bond, an amide bond or a carbonyl group. Examples of the group formed by combining two members out of $R_{201}$ to $R_{203}$ include an alkylene group (e.g., butylene, pentylene).

$X^-$ represents a non-nucleophilic anion.

Examples of the non-nucleophilic anion as $X^-$ include a sulfonate anion, a carboxylate anion, a sulfonylimide anion, a bis(alkylsulfonyl)imide anion and a tris(alkylsulfonyl)methyl anion.

The non-nucleophilic anion is an anion having an extremely low ability of causing a nucleophilic reaction, and this anion can suppress the decomposition in aging due to an intramolecular nucleophilic reaction. By virtue of this anion, the aging stability of the resist is enhanced.

Examples of the sulfonate anion include an aliphatic sulfonate anion, an aromatic sulfonate anion and a camphorsulfonate anion.

Examples of the carboxylate anion include an aliphatic carboxylate anion, an aromatic carboxylate anion and an aralkylcarboxylate anion.

The aliphatic moiety in the aliphatic sulfonate anion may be an alkyl group or a cycloalkyl group but is preferably an alkyl group having a carbon number of 1 to 30 or a cycloalkyl group having a carbon number of 3 to 30, and examples thereof include a methyl group, an ethyl group, a propyl group, an isopropyl group, an n-butyl group, an isobutyl group, a sec-butyl group, a pentyl group, a neopentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, an eicosyl group, a cyclopropyl group, a cyclopentyl group, a cyclohexyl group, an adamantyl group, a norbornyl group and a boronyl group.

The aromatic group in the aromatic sulfonate anion is preferably an aryl group having a carbon number of 6 to 14, and examples thereof include a phenyl group, a tolyl group and a naphthyl group.

Examples of the substituent for the alkyl group, cycloalkyl group and aryl group in the aliphatic sulfonate anion and aromatic sulfonate anion include a nitro group, a halogen atom (e.g., fluorine, chlorine, bromine, iodine), a carboxyl group, a hydroxyl group, an amino group, a cyano group, an alkoxy group (preferably having a carbon number of 1 to 5), a cycloalkyl group (preferably having a carbon number of 3 to 15), an aryl group (preferably having a carbon number of 6 to 14), an alkoxycarbonyl group (preferably having a carbon number of 2 to 7), an acyl group (preferably having a carbon number of 2 to 12) and an alkoxycarbonyloxy group (preferably having a carbon number of 2 to 7). As for the aryl group or ring structure in each group, examples of the substituent further include an alkyl group (preferably having a carbon number of 1 to 15).

Examples of the aliphatic moiety in the aliphatic carboxylate anion include the same alkyl group and cycloalkyl group as in the aliphatic sulfonate anion.

Examples of the aromatic group in the aromatic carboxylate anion include the same aryl group as in the aromatic sulfonate anion.

The aralkyl group in the aralkylcarboxylate anion is preferably an aralkyl group having a carbon number of 6 to 12, and examples thereof include a benzyl group, a phenethyl group, a naphthylmethyl group, a naphthylethyl group and a naphthylmethyl group.

Examples of the substituent for the alkyl group, cycloalkyl group, aryl group and aralkyl group in the aliphatic carboxylate anion, aromatic carboxylate anion and aralkylcarboxylate anion include the same halogen atom, alkyl group, cycloalkyl group, alkoxy group and alkylthio group as in the aromatic sulfonate anion.

Examples of the sulfonylimide anion include saccharin anion.

The alkyl group in the bis(alkylsulfonyl)imide anion and tris(alkylsulfonyl)methyl anion is preferably an alkyl group having a carbon number of 1 to 5, and examples thereof include a methyl group, an ethyl group, a propyl group, an isopropyl group, an n-butyl group, an isobutyl group, a sec-butyl group, a pentyl group and a neopentyl group. Examples of the substituent for this alkyl group include a halogen atom, a halogen atom-substituted alkyl group, an alkoxy group and an alkylthio group, with a fluorine atom-substituted alkyl group being preferred.

Other examples of the non-nucleophilic anion include a phosphorus fluoride anion, a boron fluoride anion and an antimony fluoride anion.

The non-nucleophilic anion of $X^-$ is preferably an aliphatic sulfonate anion with the sulfonic acid being substituted by fluorine atom at the $\alpha$-position, an aromatic sulfonate anion substituted by fluorine atom or a fluorine atom-containing group, a bis(alkylsulfonyl)imide anion with the alkyl group being substituted by fluorine atom, or a tris(alkylsulfonyl) methide anion with the alkyl group being substituted by fluorine atom. The non-nucleophilic anion is more preferably a perfluoro-aliphatic sulfonate anion having a carbon number of 4 to 8 or a fluorine atom-containing benzenesulfonate anion, still more preferably nonafluorobutanesulfonate anion, perfluorooctanesulfonate anion, pentafluorobenzenesulfonate anion or 3,5-bis(trifluoromethyl)benzenesulfonate anion.

Examples of the organic group as $R_{201}$, $R_{202}$ and $R_{203}$ include the corresponding groups in the compounds (ZI-1), (ZI-2) and (ZI-3) which are described later.

The compound may be a compound having a plurality of structures represented by formula (Z1). For example, the compound may be a compound having a structure that at least one of $R_{201}$ to $R_{203}$ in the compound represented by formula (Z1) is bonded to at least one of $R_{201}$ to $R_{203}$ in another compound represented by formula (Z1).

The component (Z1) is more preferably a compound (ZI-1), (ZI-2) or (ZI-3) described below.

The compound (ZI-1) is an arylsulfonium compound where at least one of $R_{201}$ to $R_{203}$ in formula (Z1) is an

aryl group, that is, a compound having an arylsulfonium as the cation.

In the arylsulfonium compound, $R_{201}$ to $R_{203}$ all may be an aryl group or a part of $R_{201}$ to $R_{203}$ may be an aryl group with the remaining being an alkyl group or a cycloalkyl group.

Examples of the arylsulfonium compound include a triarylsulfonium compound, a diarylalkylsulfonium compound and an aryldialkylsulfonium compound.

The aryl group in the arylsulfonium compound includes an aryl group composed of hydrocarbon and a heteroaryl group having a heteroatom such as nitrogen atom, sulfur atom and oxygen atom. The aryl group composed of hydrocarbon is preferably a phenyl group or a naphthyl group, more preferably a phenyl group. Examples of the heteroaryl group include a pyrrole group, an indole group, a carbazole group, a furan group and a thiophene group, with an indole group being preferred. In the case where the arylsulfonium compound has two or more aryl groups, these two or more aryl groups may be the same of different.

The alkyl group or cycloalkyl group which is present, if desired, in the arylsulfonium compound is preferably a linear or branched alkyl group having a carbon number of 1 to 15 or a cycloalkyl group having a carbon number of 3 to 15, and examples thereof include a methyl group, an ethyl group, a propyl group, an n-butyl group, a sec-butyl group, a tert-butyl group, a cyclopropyl group, a cyclobutyl group and a cyclohexyl group.

The aryl group, alkyl group and cycloalkyl group of $R_{201}$ to $R_{203}$ each may have, as the substituent, an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 14), an alkoxy group (for example, an alkoxy group having a carbon number of 1 to 15), a halogen atom, a hydroxyl group or a phenylthio group. The substituent is preferably a linear or branched alkyl group having a carbon number of 1 to 12, a cycloalkyl group having a carbon number of 3 to 12, or a linear, branched or cyclic alkoxy group having a carbon number of 1 to 12, and most preferably an alkyl group having a carbon number of 1 to 4, or an alkoxy group having a carbon number of 1 to 4. The substituent may be substituted to any one of three members $R_{201}$ to $R_{203}$ or may be substituted to all of these three members. In the case where $R_{201}$ to $R_{203}$ are an aryl group, the substituent is preferably substituted at the p-position of the aryl group.

The compound (ZI-2) is described below.

The compound (ZI-2) is a compound where $R_{201}$ to $R_{203}$ in formula (ZI) each independently represents an organic group having no aromatic ring. The aromatic ring as used herein includes an aromatic ring containing a heteroatom.

The aromatic ring-free organic group as $R_{201}$ to $R_{203}$ generally has a carbon number of 1 to 30, preferably from 1 to 20.

$R_{201}$ to $R_{203}$ each is independently preferably an alkyl group, a cycloalkyl group, an allyl group or a vinyl group, more preferably a linear or branched 2-oxoalkyl group, a 2-oxocycloalkyl group or an alkoxycarbonylmethyl group, still more preferably a linear or branched 2-oxoalkyl group.

The alkyl group and cycloalkyl group of $R_{201}$ to $R_{203}$ are preferably a linear or branched alkyl group having a carbon number of 1 to 10 (e.g., methyl, ethyl, propyl, butyl, pentyl) and a cycloalkyl group having a carbon number of 3 to 10 (e.g., cyclopentyl, cyclohexyl, norbornyl). The alkyl group is more preferably a 2-oxoalkyl group or an alkoxycarbonylmethyl group. The cycloalkyl group is more preferably a 2-oxocycloalkyl group.

The 2-oxoalkyl group may be either linear or branched and is preferably a group having >C=O at the 2-position of the above-described alkyl group.

The 2-oxocycloalkyl group is preferably a group having >C=O at the 2-position of the above-described cycloalkyl group.

The alkoxy group in the alkoxycarbonylmethyl group is preferably an alkyl group having a carbon number of 1 to 5 (e.g., methoxy, ethoxy, propoxy, butoxy, pentoxy).

$R_{201}$ to $R_{203}$ each may be further substituted by a halogen atom, an alkoxy group (for example, an alkoxy group having a carbon number of 1 to 5), a hydroxyl group, a cyano group or a nitro group.

The compound (ZI-3) is a compound represented by the following formula (ZI-3), and this is a compound having a phenacylsulfonium salt structure.

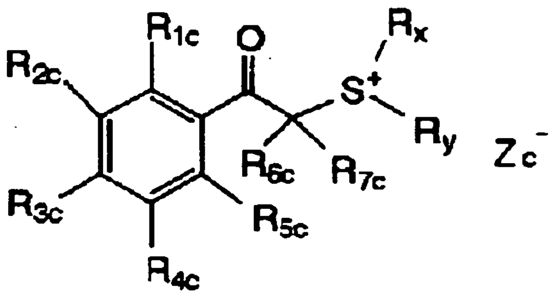

(ZI-3)

In formula (ZI-3), $R_{1c}$ to $R_{5c}$ each independently represents a hydrogen atom, an alkyl group, a cycloalkyl group, an alkoxy group or a halogen atom.

$R_{6c}$ and $R_{7c}$ each independently represents a hydrogen atom, an alkyl group or a cycloalkyl group.

$R_x$ and $R_y$ each independently represents an alkyl group, a cycloalkyl group, an allyl group or a vinyl group.

Any two or more members out of $R_{1c}$ to $R_{7c}$ or a pair of $R_x$ and $R_y$ may combine with each other to form a ring structure. The ring structure may contain an oxygen atom, a sulfur atom, an ester bond or an amide bond. Examples of the group formed by combining any two or more members out of $R_{1c}$ to $R_{7c}$ or a pair of $R_x$ and Ry include a butylene group and a pentylene group.

$Zc^-$ represents a non-nucleophilic anion, and examples thereof are the same as those of the non-nucleophilic anion of $X^-$ in formula (ZI).

The alkyl group as $R_{1c}$ to $R_{7c}$ may be either linear or branched and this is, for example, an alkyl group having a carbon number of 1 to 20, preferably a linear or branched alkyl group having a carbon number of 1 to 12 (for example, a methyl group, an ethyl group, a linear or branched propyl group, a linear or branched butyl group, or a linear or branched pentyl group). The cycloalkyl group is, for example, a cyclic alkyl group having a carbon number of 3 to 8 (e.g., cyclopentyl, cyclohexyl).

The alkoxy group as $R_{1c}$ to $R_{5c}$ may be linear, branched or cyclic and this is, for example, an alkoxy group having a carbon number of 1 to 10, preferably a linear or branched alkoxy group having a carbon number of 1 to 5 (for example, a methoxy group, an ethoxy group, a linear or branched propoxy group, a linear or branched butoxy group, or a linear or branched pentoxy group) or a cyclic alkoxy group having a carbon number of 3 to 8 (e.g., cyclopentyloxy, cyclohexyloxy).

A compound where any one of $R_{1c}$ to $R_{5c}$ is a linear or branched alkyl group, a cycloalkyl group or a linear, branched or cyclic alkoxy group is preferred, and a compound where the sum of carbon numbers of $R_{1c}$ to $R_{5c}$ is from 2 to 15 is more preferred. In this case, the solubility in a solvent is more enhanced, and production of particles during storage can be suppressed.

The alkyl group and cycloalkyl group as $R_x$ and $R_y$ include the same alkyl group and cycloalkyl group as in $R_{1c}$ to $R_{7c}$. A 2-oxoalkyl group, a 2-oxocycloalkyl group and an alkoxycarbonylmethyl group are preferred.

The 2-oxoalkyl group and 2-oxocycloalkyl group include a group having >C=O at the 2-position of the alkyl group or cycloalkyl group as $R_{1c}$ to $R_{7c}$.

The alkoxy group in the alkoxycarbonylmethyl group includes the same alkoxy group as in $R_{1c}$ to $R_{5c}$

$R_x$ and $R_y$ each is preferably an alkyl or cycloalkyl group having a carbon number of 4 or more, more preferably 6 or more, still more preferably 8 or more.

In formulae (ZII) and (ZIII), $R_{204}$ to $R_{207}$ each independently represents an aryl group, an alkyl group or a cycloalkyl group.

The aryl group of $R_{204}$ to $R_{207}$ is preferably a phenyl group or a naphthyl group, more preferably a phenyl group.

The alkyl group and cycloalkyl group in $R_{204}$ to $R_{207}$ are preferably a linear or branched alkyl group having a carbon number of 1 to 10 (e.g., methyl, ethyl, propyl, butyl, pentyl) and a cycloalkyl group having a carbon number of 3 to 10 (e.g., cyclopentyl, cyclohexyl, norbornyl).

Examples of the substituent which $R_{204}$ to $R_{207}$ each may have include an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 15), an alkoxy group (for example, an alkoxy group having a carbon number of 1 to 15), a halogen atom, a hydroxyl group and a phenylthio group.

$X^-$ represents a non-nucleophilic anion, and examples thereof are the same as those of the non-nucleophilic anion of $X^-$ in formula (ZI).

Other preferred examples of the compound capable of decomposing under irradiation with actinic rays or radiation to generate an acid, which can be used in combination, include the compounds represented by the following formulae (ZIV), (ZV) and (ZVI).

$Ar_3-SO_2-SO_2-Ar_4$

ZIV

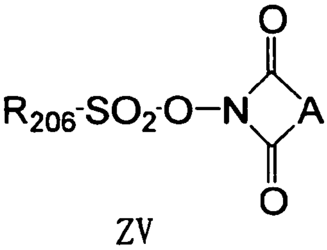

ZV

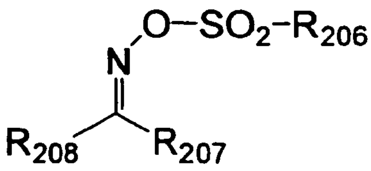

ZVI

In formulae (ZIV) to (ZVI), $Ar_3$ and $Ar_4$ each independently represents an aryl group.

$R_{206}$, $R_{207}$ and $R_{208}$ each independently represents an alkyl group, a cycloalkyl group or an aryl group.

A represents an alkylene group, an alkenylene group or an arylene group.

Among the compounds capable of decomposing upon irradiation with actinic rays or radiation, which may be used in combination, the compounds represented by formulae (ZI) to (ZIII) are preferred.

The compound capable of decomposing upon irradiation with actinic rays or radiation, which may be used in combination, is preferably a compound capable of generating a sulfonic acid having one sulfonic acid, more preferably a compound capable of generating a monovalent perfluoroalkanesulfonic acid, or a compound capable of generating an aromatic sulfonic acid substituted by fluorine atom or a fluorine atom-containing group, still more preferably a sulfonium salt of a monovalent perfluoroalkanesulfonic acid.

Out of the compounds capable of decomposing upon irradiation with actinic rays or radiation to generate an acid, which may be used in combination, more preferred compounds are set forth below.

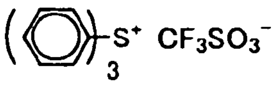

(z1)

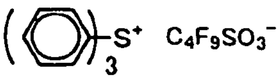

(z2)

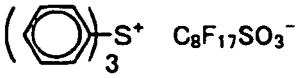

(z3)

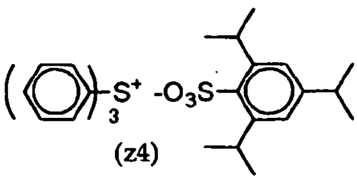

(z4)

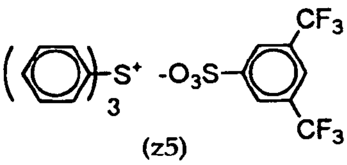

(z5)

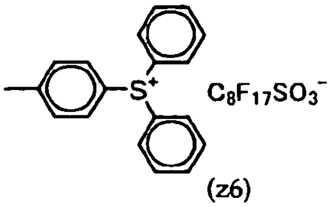

(z6)

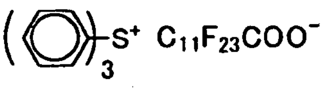

(z7)

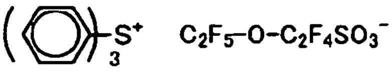

(z8)

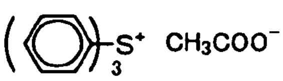

(z9)

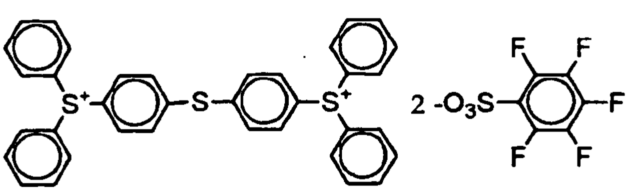

(z10)

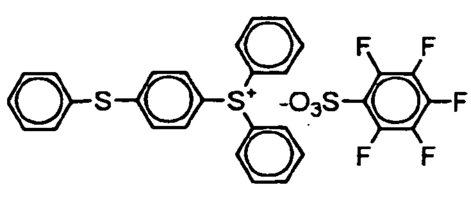

(z11)

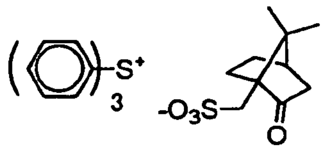
(z12)

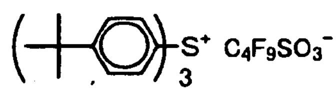
(z13)

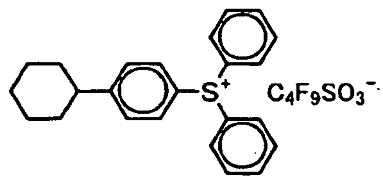
(z14)

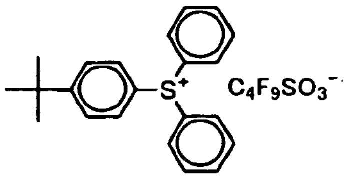
(z15)

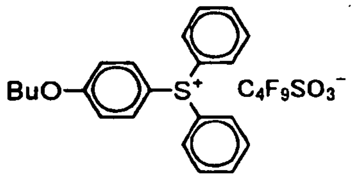
(z16)

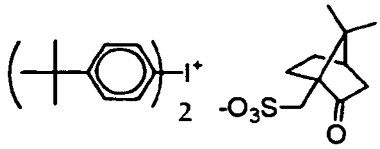
(Z17)

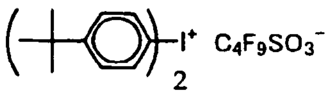
(z18)

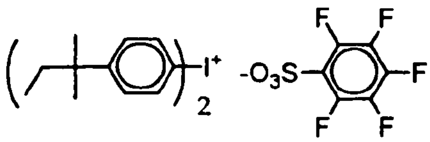
(z19)

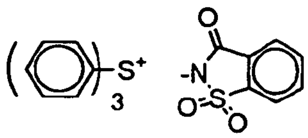
(z20)

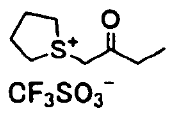
(z21)

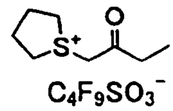
(z22)

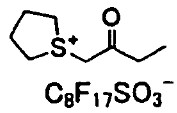
(z23)

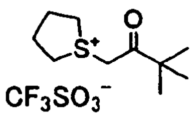
(z24)

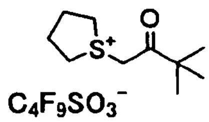
(z25)

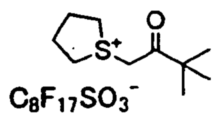
(z26)

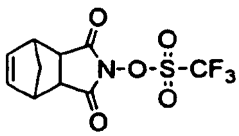
(z27)

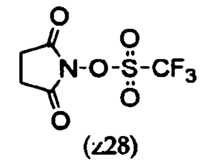
(z28)

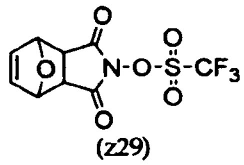
(z29)

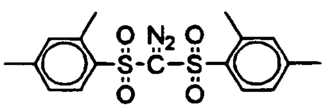
(z30)

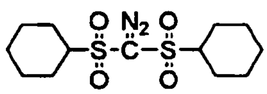
(z31)

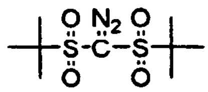
(z32)

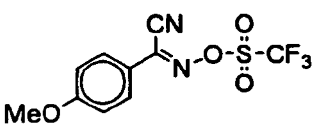
(z33)

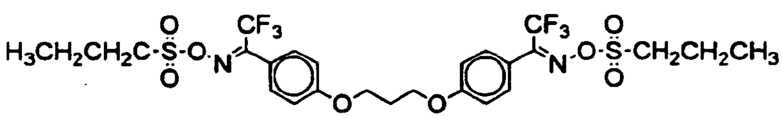
(z34)

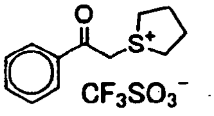
(z35)

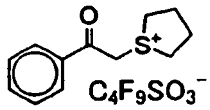
(z36)

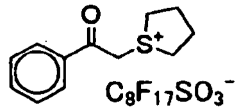
(z37)

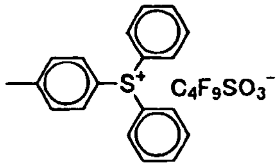
(z38)

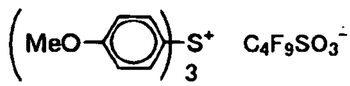
(z39)

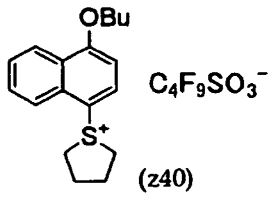
(z40)

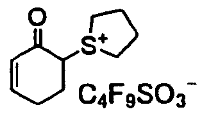
(z41)

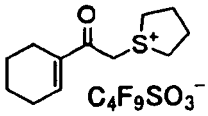
(z42)

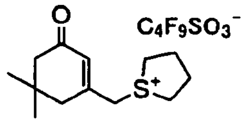
(z43)

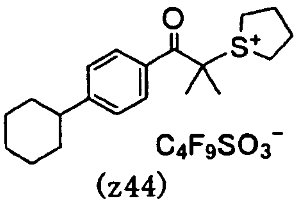
(z44)

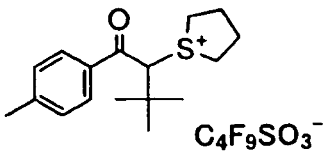
(z45)

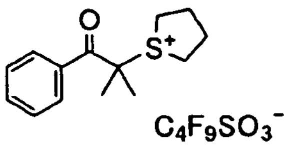
(z46)

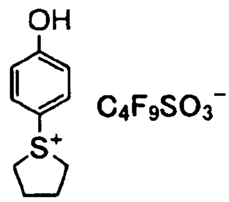
(z47)

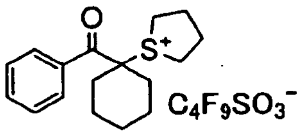
(z48)

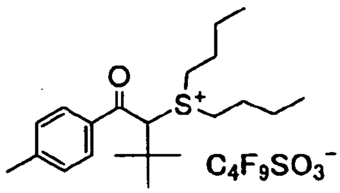
(z49)

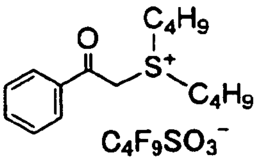
(z50)

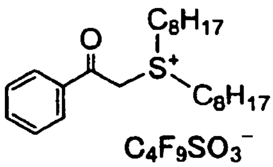
(z51)

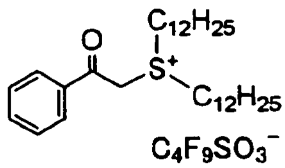
(z52)

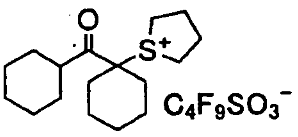
(z53)

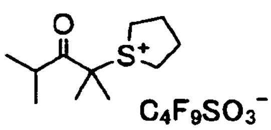
(z54)

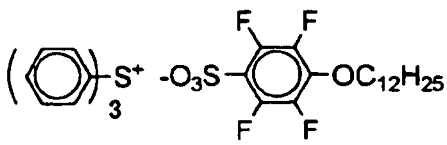
(z55)

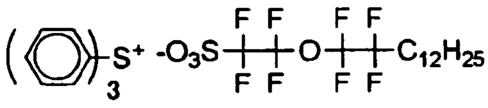

(z56)

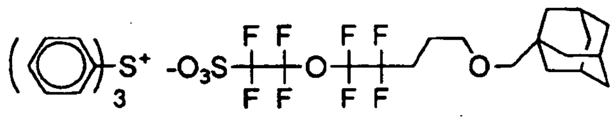

(z57)

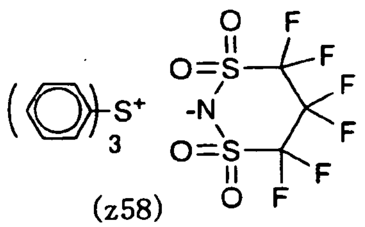

(z58)

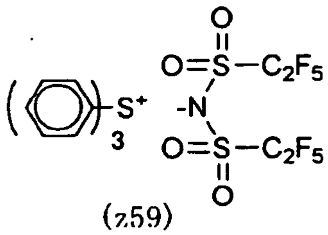

(z59)

[3] Nitrogen-containing basic compound (C)

In the present invention, a nitrogen-containing basic compound is preferably used from the standpoint of, for example, enhancing the performance (e.g., resolving power) or storage stability.

The nitrogen-containing basic compound preferably usable in the present invention is a compound having basicity stronger than that of phenol.

The preferred chemical environment thereof includes structures of the following formulae (A) to (E). The structures of formulae (B) to (E) each may form a part of a ring structure.

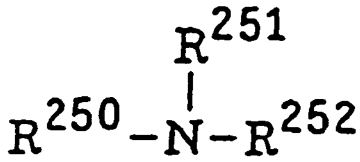

(A)

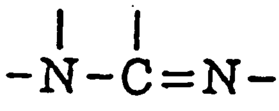

(B)

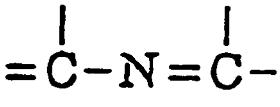

(C)

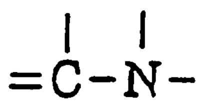

(D)

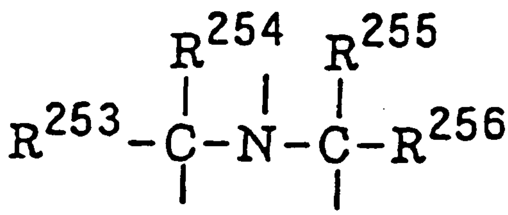

(E)

In the formulae, $R^{250}$, $R^{251}$ and $R^{252}$, which may be the same or different, each represents a hydrogen atom, an alkyl group having a carbon number of 1 to 20, a cycloalkyl group having a carbon number of 3 to 20 or an aryl group having a carbon number of 6 to 20, and $R^{251}$ and $R^{252}$ may combine with each other to form a ring. Also, the alkyl group, cycloalkyl group and aryl group each may be substituted by a hydroxyl group, an amino group or the like.

$R^{253}$, $R^{254}$, $R^{255}$ and $R^{256}$, which may be the same or different, each represents an alkyl group having a carbon number of 1 to 20.

The compound is more preferably a nitrogen-containing basic compound having two or more nitrogen atoms differing in the chemical environment within one molecule, still more preferably a compound containing both an amino group and a nitrogen atom-containing ring structure, or a compound having an alkylamino group.

Specific preferred examples thereof include guanidine, aminopyridine, aminoalkylpyridine, aminopyrrolidine, indazole, imidazole, pyrazole, pyrazine, pyrimidine, purine, imidazoline, pyrazoline, piperazine, aminomorpholine and aminoalkylmorpholine. These compounds each may have a substituent, and preferred examples of the substituent include an amino group, an aminoalkyl group, an alkylamino group, an aminoaryl group, an arylamino group, an alkyl

group, an alkoxy group, an acyl group, an acyloxy group, an aryl group, an aryloxy group, a nitro group, a hydroxyl group and a cyano group.

More preferred examples of the compound include, but are not limited to, guanidine, 1,1-dimethylguanidine, 1,1,3,3-tetramethylguanidine, imidazole, 2-methylimidazole, 4-methylimidazole, N-methylimidazole, 2-phenylimidazole, 4,5-diphenylimidazole, 2,4,5-triphenylimidazole, 2-aminopyridine, 3-aminopyridine, 4-aminopyridine, 2-dimethylaminopyridine, 4-dimethylaminopyridine, 2-diethylaminopyridine, 2-(aminomethyl)pyridine, 2-amino-3-methylpyridine, 2-amino-4-methylpyridine, 2-amino-5-methylpyridine, 2-amino-6-methylpyridine, 3-aminoethylpyridine, 4-aminoethylpyridine, 3-aminopyrrolidine, piperazine, N-(2-aminoethyl)piperazine, N-(2-aminoethyl)piperidine, 4-amino-2,2,6,6-tetramethylpiperidine, 4-piperidinopiperidine, 2-iminopiperidine, 1-(2-aminoethyl)pyrrolidine, pyrazole, 3-amino-5-methylpyrazole, 5-amino-3-methyl-1-p-tolylpyrazole, pyrazine, 2-(aminomethyl)-5-methylpyrazine, pyrimidine, 2,4-diaminopyrimidine, 4,6-dihydroxypyrimidine, 2-pyrazoline, 3-pyrazoline, N-aminomorpholine and N-(2-aminoethyl)-morpholine.

A tetraalkylammonium salt-type nitrogen-containing basic compound may also be used. Among such compounds, a tetraalkylammonium hydroxide having a carbon number of 1 to 8 (e.g., tetramethylammonium hydroxide, tetraethylammonium hydroxide, tetra-(n-butyl)ammonium hydroxide) is preferred.

One of these nitrogen-containing basic compounds is used alone, or two or more species thereof are used in combination.

As for the ratio of the acid generator and the nitrogen-containing basic compound used in the composition, the (total amount of acid generator)/(nitrogen-containing basic compound) (ratio by mol) is preferably from 2.5 to 300. The (total amount of acid generator)/(nitrogen-containing basic compound) (ratio by mol) is more preferably from 5.0 to 200, still more preferably from 7.0 to 150.

[4] Surfactants

In the present invention, surfactants can be used, and use thereof is preferred in view of film-forming property, adhesion of pattern, reduction of development defect, and the like.

Specific examples of the surfactant include a nonionic surfactant such as polyoxyethylene alkyl ethers (e.g., polyoxyethylene lauryl ether, polyoxyethylene stearyl ether, polyoxyethylene cetyl ether, polyoxyethylene oleyl ether), polyoxyethylene alkylallyl ethers (e.g., polyoxyethylene octylphenol ether, polyoxyethylene nonylphenol ether), polyoxyethylene·polyoxypropylene block copolymers, sorbitan fatty acid esters (e.g., sorbitan monolaurate, sorbitan monopalmitate, sorbitan monostearate, sorbitan monooleate, sorbitan trioleate, sorbitan tristearate) and polyoxyethylene sorbitan fatty acid esters (e.g., polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate); a fluorine-containing surfactant and a silicon-containing surfactant, such as EFtop EF301, EF303, EF352 (produced by Shin-Akita Chemical Co., Ltd.), Megafac F171, F173 (produced by Dainippon Ink & Chemicals, Inc.), Florad FC430, FC431 (produced by Sumitomo 3M Inc.), Asahiguard AG710, Surflon S-382, SC101, SC102, SC103, SC104, SC105 and SC106 (produced by Asahi Glass Co., Ltd.) and Troysol S-366 (produced by Troy Chemical Industries, Inc.); organosiloxane polymer KP-341 (produced by Shin-Etsu Chemical Co., Ltd.); and acrylic acid-based or methacrylic acid-based (co)polymer Polyflow No. 75 and No. 95 (produced by Kyoeisha Chemical Co., Ltd.).

The amount of such a surfactant blended is usually 2 parts by mass or less, preferably 1 part by mass or less, per 100 parts by mass of the solid content in the composition of the present invention.

One of these surfactants may be used alone or several species thereof may be added in combination.

As for the surfactant, the composition preferably contains any one species of fluorine- and/or silicon-containing surfactants (a fluorine-containing surfactant, a silicon-containing surfactant or a surfactant containing both a fluorine atom and a silicon atom), or two or more species thereof.

Examples of such a surfactant include the surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, JP-A-2002-277862 and U.S. Patents 5,405,720, 5,360,692, 5,529,881, 5,296,330, 5,436,098, 5,576,143, 5,294,511 and 5,824,451. The following commercially available surfactants each may also be used as it is.

Examples of the commercially available surfactant which can be used include a fluorine-containing or silicon-containing surfactant such as EFtop EF301 and EF303 (produced by Shin-Akita Chemical Co., Ltd.), Florad FC430 and 431 (produced by Sumitomo 3M Inc.), Megafac F171, F173, F176, F189 and R08 (produced by Dainippon Ink & Chemicals, Inc.), Surflon S-382, SC101, 102, 103, 104, 105 and 106 (produced by Asahi Glass Co., Ltd.), and Troysol S-366 (produced by Troy Chemical Industries, Inc.). In addition, polysiloxane polymer KP-341 (produced by Shin-Etsu Chemical Co., Ltd.) may also be used as the silicon-containing surfactant.

Other than those known surfactants, a surfactant using a polymer having a fluoro-aliphatic group derived from a fluoro-aliphatic compound produced by a telomerization process (also called a telomer process) or an oligomerization process (also called an oligomer process) may be used. The fluoro-aliphatic compound can be synthesized by the method described in JP-A-2002-90991.

The polymer having a fluoro-aliphatic group is preferably a copolymer of a fluoro-aliphatic group-containing monomer with a (poly(oxyalkylene)) acrylate and/or a (poly(oxyalkylene)) methacrylate, and the polymer may have an irregular distribution or may be a block copolymer. Examples of the poly(oxyalkylene) group include a poly(oxyethylene) group, a poly(oxypropylene) group and a poly(oxybutylene) group. This group may also be a unit having alkylenes differing in the chain length within the same chain, such as block-linked poly(oxyethylene, oxypropylene and oxyethylene) and block-linked poly-(oxyethylene and oxypropylene). Furthermore, the copolymer of a fluoro-aliphatic group-containing monomer with a (poly(oxyalkylene)) acrylate (or methacrylate) may be not only a binary copolymer but also a ternary or higher copolymer obtained by simultaneously copolymerizing two or more different fluoro-aliphatic group-containing monomers or two or more different (poly(oxyalkylene)) acrylates (or methacrylates).

Examples thereof include commercially available surfactants such as Megafac F178, F-470, F-473, F-475, F-476 and F-472 (produced by Dainippon Ink & Chemicals, Inc.), and further include a copolymer of a $C_6F_{13}$ group-containing acrylate (or methacrylate) with a (poly(oxyalkylene)) acrylate (or methacrylate), a copolymer of a $C_6F_{13}$ group-containing acrylate (or methacrylate) with (poly(oxyethylene)) acrylate (or methacrylate) and (poly(oxypropylene)) acrylate (or methacrylate), a copolymer of a $C_8F_{17}$ group-containing acrylate (or methacrylate) with a (poly(oxyalkylene)) acrylate (or methacrylate), and a copolymer of a $C_8F_{17}$ group-containing acrylate (or methacrylate) with (poly(oxyethylene)) acrylate (or methacrylate) and (poly(oxypropylene)) acrylate (or methacrylate).

The amount of the surfactant used is preferably from 0.0001 to 2 mass%, more preferably from 0.001 to 1 mass%, based on the entire amount of the positive resist composition (excluding the solvent).

[5] Other components

The positive resist composition of the present invention may further contain, if desired, a dye, a photo-base generator and the like.

1. Dye

In the present invention, a dye may be used.

A suitable dye includes an oily dye and a basic dye. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Chemical Industries Co., Ltd.), Crystal Violet (CI42555), Methyl Violet (CI42535), Rhodamine B (CI45170B), Malachite Green (CI42000) and Methylene Blue (CI52015).

2. Photo-base generator

Examples of the photo-base generator which can be added to the composition of the present invention include the compounds described in JP-A-4-151156, JP-A-4-162040, JP-A-5-197148, JP-A-5-5995, JP-A-6-194834, JP-A-8-146608, JP-A-10-83079 and European Patent 622,682. Specific examples of the photo-base generator which can be suitably used include 2-nitrobenzyl carbamate, 2,5-dinitrobenzylcyclohexyl carbamate, N-cyclohexyl-4-methylphenylsulfonamide and 1,1-dimethyl-2-phenylethyl-N-isopropyl carbamate. Such a photo-base generator is added for the purpose of improving the resist profile or the like.

3. Solvents

The positive resist composition of the present invention is dissolved in a solvent capable of dissolving respective components described above and then coated on a support. Usually, the concentration is, in terms of the solid content concentration of all resist components, preferably from 2 to 30 mass%, more preferably from 3 to 25 mass%.

Preferred examples of the solvent used here include ethylene dichloride, cyclohexanone, cyclopentanone, 2-heptanone, γ-butyrolactone, methyl ethyl ketone, ethylene glycol monomethyl ether, ethylene glycol monoethyl ether, 2-methoxyethyl acetate, ethylene glycol monoethyl ether acetate, propylene glycol monomethyl ether, propylene glycol monomethyl ether acetate, toluene, ethyl acetate, methyl lactate, ethyl lactate, methyl methoxypropionate, ethyl ethoxypropionate, methyl pyruvate, ethyl pyruvate, propyl pyruvate, N,N-dimethylformamide, dimethylsulfoxide, N-methylpyrrolidone and tetrahydrofuran. One of these solvents is used alone, or several species thereof are mixed and used.

The positive resist composition of the present invention is coated on a substrate to form a thin film. The thickness of this coated film is preferably from 0.05 to 4.0 μm.

In the present invention, a commercially available inorganic or organic antireflection film may be used, if desired. Furthermore, an antireflection film may also be used by coating it on the upper resist layer.

The antireflection film used as the underlayer of the resist may be either an inorganic film type such as titanium, titanium dioxide, titanium nitride, chromium oxide, carbon and amorphous silicon, or an organic film type comprising a

light absorbent and a polymer material. The former requires equipment for the film formation, such as vacuum deposition apparatus, CVD apparatus and sputtering apparatus. Examples of the organic antireflection film include a film comprising a diphenylamine derivative and formaldehyde-modified melamine resin condensate, an alkali-soluble resin and a light absorbent described in JP-B-7-69611 (the term "JP-B" as used herein means an "examined Japanese patent publication"), a reaction product of a maleic anhydride copolymer and a diamine-type light absorbent described in U.S. Patent 5,294,680, a film comprising a resin binder and a methylolmelamine-based heat crosslinking agent described in JP-A-6-118631, an acrylic resin-type antireflection film containing a carboxylic acid group, an epoxy group and a light absorbing group within the same molecule described in JP-A-6-118656, a film comprising methylolmelamine and a benzophenone-based light absorbent described in JP-A-8-87115, and a film obtained by adding a low molecular light absorbent to a polyvinyl alcohol resin described in JP-A-8-179509.

Also, the organic antireflection film may be a commercially available organic antireflection film such as DUV-30 Series, DUV-40 Series (produced by Brewer Science, Inc.), AR-2, AR-3 and AR-5 (produced by Shipley Co., Ltd.).

In the production or the like of a precision integrated circuit device, the step of forming a pattern on a resist film is performed by coating the positive resist composition of the present invention on a substrate (for example, a silicon/silicon dioxide-coated substrate, a glass substrate, an ITO substrate or a quartz/chromium oxide-coated substrate), irradiating thereon KrF excimer laser light, ArF excimer laser light, F2 excimer laser light, X-ray, electron beam, ion beam or EUV, and then subjecting the resist film to heating, development, rinsing and drying, whereby a good resist pattern can be formed.

The alkali developer which can be used for the resist composition of the present invention is an aqueous solution of alkalis (usually, from 0.1 to 20 mass%) such as inorganic alkalis (e.g., sodium hydroxide, potassium hydroxide, sodium carbonate, sodium silicate, sodium metasilicate, aqueous ammonia), primary amines (e.g., ethylamine, n-propylamine), secondary amines (e.g., diethylamine, di-n-butylamine), tertiary amines (e.g., triethylamine, methyldiethylamine), alcohol amines (e.g., dimetylethanolamine, triethanolamine), quaternary ammonium salts (e.g., tetramethylammonium hydroxide, tetraethylammonium hydroxide, choline) and cyclic amines (e.g., pyrrole, piperidine). This aqueous solution of alkalis may be used after adding thereto alcohols such as isopropyl alcohol or a surfactant such as nonionic surfactant in an appropriate amount.

Among these developers, preferred is a quaternary ammonium salt, more preferred are tetramethylammonium hydroxide and choline.

The pH of the alkali developer is usually from 10.0 to 15.0.

## EXAMPLES

The present invention is described in greater detail below by referring to Examples, but the contents of the present invention should not be construed as being limited thereto.

Synthesis Example 1 (Synthesis of Binder (T-1)):

In a reaction vessel, 65.28 g (0.05 mol) of Phenol Compound (1) shown below was dissolved in 200 g of propylene glycol monomethyl ether acetate (hereinafter simply referred to as "PGMEA"). This solution was depressurized to 20 mmHg at 60°C to remove by distillation about 40 g of the solvent together with water remaining in the system. After cooling to 20°C, 49.75 g (0.18 mol) of Protective Reactive Agent (1) and 2.5 g of p-toluenesulfonic acid were added thereto, and the resulting solution was stirred at room temperature for 2 hours. Subsequently, 3.0 g of triethylamine was added to effect neutralization, and a washing operation with 50 g of ethyl acetate and 50 g of water was performed three times. Thereafter, the amount of the solvent was adjusted to obtain a 30 mass% solution of Binder (T-1) which is the compound as the component (A). From the 1H and 13C-NMR analyses, the protection ratio based on all phenolic OH groups was found to be 59.3%.

Synthesis Example 2 (Synthesis of Binder (T-3)):

In a reaction vessel, 65.28 g (0.05 mol) of Phenol Compound (1) shown below, 200 g of PGMEA, 43.5 g (0.30 mol) of potassium carbonate and 61.5 g (0.31 mol) of Protective Reactive Agent (4) (tert-Bu bromoacetate) were added, and the reaction solution was heated to 100°C. After stirring 3 hours, the reaction solution was allowed to cool to room temperature, neutralized by adding an aqueous 0.1N-HCl solution, and washed by adding 50 ml of ethyl acetate and 50 ml of distilled water. Thereafter, the amount of the solvent was adjusted to obtain a 30 mass% solution of Binder (T-3). From the 1H and 13C-NMR analyses, the protection ratio based on all phenolic OH groups was found to be 63.7%.

Synthesis Example 3 (Synthesis of Binder (T-5)):

In a reaction vessel, 27.42 g (0.05 mol) of Phenol Compound (2) shown below, 150 ml of PGMEA, 20.1 g (0.20 mol) of triethylamine and 2.0 g of 4-dimethylaminopyridine were added and stirred. Subsequently, a tetrahydrofuran 100 ml solution containing 54.02 g (0.2475 mol) of Protective Reactive Agent (5) (di-tert-butyl dicarbonate) was added dropwise over 2 hours. After the dropwise addition, the reaction solution was further stirred for 3 hours, neutralized with an aqueous 0.1N HCl solution, and washed and extracted with 50 ml of ethyl acetate and 50 ml of distilled water. The organic layer was separated and then, the amount of the solvent was adjusted to obtain a 30 mass% solution of Binder (T-5). From the 1H and 13C-NMR analyses, the protection ratio based on all phenolic OH groups was found to be 69.3%.

Binders (T-2), (T-4) and (T-6) to (T-8) were obtained by the same method as in Synthesis Examples above except for changing the phenol compound or protective reactive agent used.

The structures of Phenol Compounds (1) to (3) and Protective Reactive Agents (1) to (5) are shown below.

Phenol Compound (1):

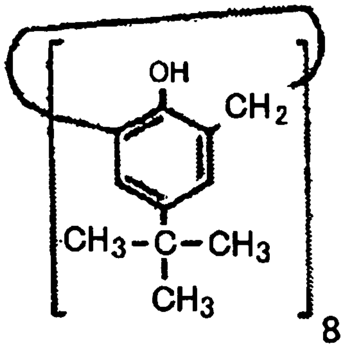

Phenol Compound (2):

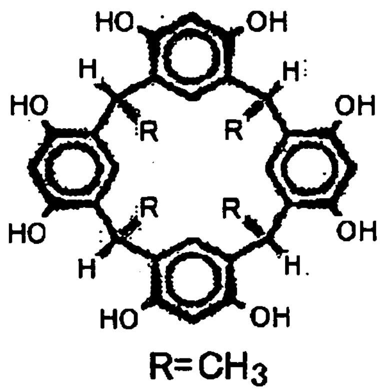

Phenol Compound (3):

A mixture of ortho-substitution/para-substitution.

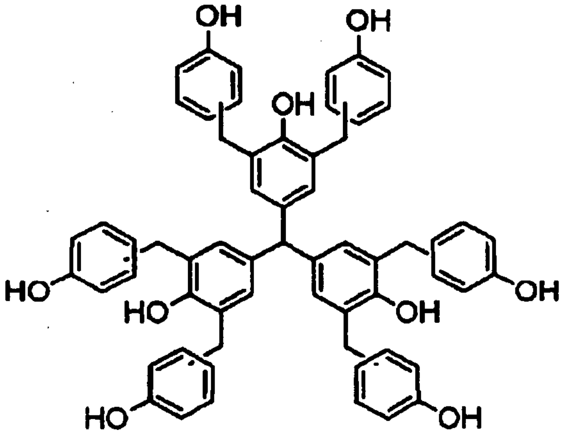

Protective Reactive Agent (1):

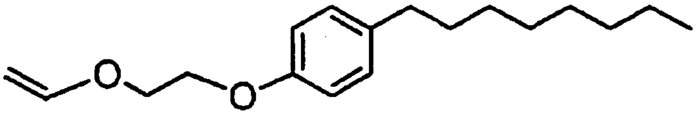

Protective Reactive Agent (2):

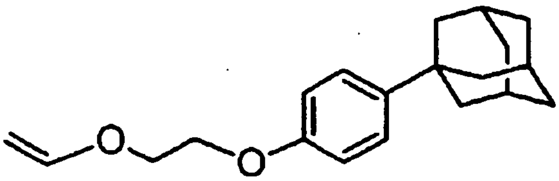

Protective Reactive Agent (3) :

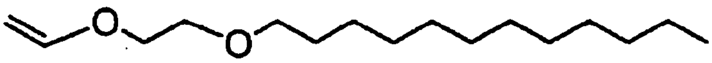

Protective Reactive Agent (4):

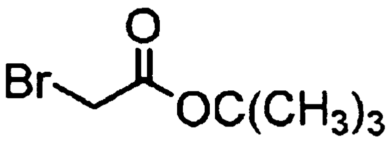

Protective Reactive Agent (5):

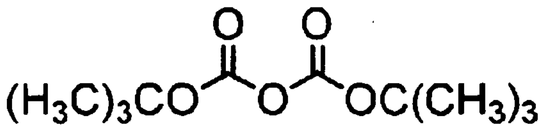

In the case of using Protective Reactive Agents (1) to (3), the phenolic OH in Phenol Compounds (1) to (3) is protected by acetal. In the case of using Protective Reactive Agent (4), the phenolic OH in Phenol Compounds (1) to (3) is protected by tert-butoxycarbonylmethyl. In the case of using Protective Reactive Agent (5), the phenolic OH in Phenol Compounds (1) to (3) is protected by tert-butoxycarbonyl.

Phenol Compounds (1) to (3) and Protective Reactive Agents (1) to (5) all are easily available or can be synthesized by using an ordinary method.

The mother nucleus phenol compound and protective reactive agent used in the binder synthesized, and the protective ratio are shown together in Table 1.

[Table 1]

| Binder | Mother Nucleus Phenol Compound | Protective Reactive Agent | Protection Ratio (mol% based on all phenolic OH groups) |
|---|---|---|---|
| T-1 | (1) | (1) | 59.3 |
| T-2 | (1) | (3) | 70.5 |
| T-3 | (1) | (4) | 63.7 |
| T-4 | (2) | (2) | 69.6 |
| T-5 | (2) | (5) | 69.3 |
| T-6 | (2) | (1) | 66.9 |
| T-7 | (1) | (2) | 68.6 |
| T-8 | (3) | (4) | 79.2 |

Examples 1 to 18 and Comparative Examples 1 to 5:

(i) Preparation of Resist Composition

As shown in Table 2 below,
a binder of the present invention: 0.945 g (94.5 mass% of the solid content in the resist),
an additive resin: in an amount shown in Table 2 below (added to replace the binder of the present invention),
an acid generator: 0.05 g (5.0 mass% of the solid content in the resist),
a basic compound: 0.003 g (0.3 mass% of the solid content in the resist), and
a surfactant: 0.002 g (0.2 mass% of the solid content in the resist; 99.7 ppm based on the entire resist solution)
were dissolved in a solvent to prepare a solution having a solid content concentration of 5.0 mass%, and this solution was filtered through a 0.1 μm polytetrafluoroethylene filter to obtain positive resist solutions of Examples 1 to 18 and Comparative Examples 1 to 5.

(ii) Formation and Evaluation of Positive Resist Pattern (EB)

The positive resist solution prepared above was coated on a silicon wafer subjected to a hexamethyldisilazane treatment, by using a spin coater and then dried under heating at 120°C for 90 seconds to form a positive resist film having a thickness of 0.3 μm. This resist film was then irradiated with electron beams by using an electron beam image-drawing apparatus (HL750, manufactured by Hitachi Ltd., accelerating voltage: 50 KeV). After the irradiation, the resist film was baked at 110°C for 90 seconds, dipped in an aqueous 2.38 mass% tetramethylammonium hydroxide (TMAH) solution for 60 seconds, rinsed with water for 30 seconds and then dried. The obtained pattern was evaluated by the following methods.

[Sensitivity]

The cross-sectional profile of the pattern obtained was observed by using a scanning electron microscope (S-4300, manufactured by Hitachi, Ltd.). The minimum irradiation energy for resolving a 150-nm line (line:space = 1:1) was defined as the sensitivity.

[Resolving Power]

The limiting resolving power (capable of separating and resolving the line and space) at the irradiation dose of giving the above-described sensitivity was defined as the resolving power.

[Pattern Profile]

The cross-section in the portion having a line width of 150 nm (line/space=1:1) was observed by SEM (S-8840, manufactured by Hitachi, Ltd.) and evaluated according to the following criteria.

A: The angle between the pattern side wall and the substrate and the angle between the pattern side wall and the pattern surface both are 90±2°.
B: The angle between the pattern side wall and the substrate is 90±2°, but the angle between the pattern side wall and the pattern surface is from 85° to less than 88° or from 92° to less than 95°; or the angle between the pattern side wall and the pattern surface is 90±2°, but the angle between the pattern side wall and the substrate is from 85° to less than 88° or from 92° to less than 95°.
C: The angle between the pattern side wall and the substrate and the angle between the pattern side wall and the pattern surface both are from 85° to less than 88° or from 92° to less than 95°.
D: The angle between the pattern side wall and the substrate is less than 85° or 95° or more, a T-top profile is observed, or the pattern surface as a whole is rounded.

[Line Edge Roughness]

With respect to the region of 50 μm in the longitudinal direction of a 150-nm line pattern at the irradiation dose of giving the above-described sensitivity, the distance from the reference line where the edge should be present was measured at arbitrary 30 points by using a scanning electron microscope (S-9220, manufactured by Hitachi, Ltd.), the standard deviation was determined, and the 3σ was calculated.

[Outgassing]

The numeric value determined according to the following formula from the film thickness (F1) after exposure with the exposure amount obtained above in the evaluation of sensitivity and the film thickness (F0) before exposure is used as the numeric value of outgassing.

$$\text{Outgassing} = ((F0) - (F1))/F0$$

The evaluation results are shown in Table 2.

[Table 2]

| | | Composition | | | | | |
|---|---|---|---|---|---|---|---|
| | | Binder (concentration in solid content of resist, mass%) | Additive Resin (mass/g) (concentration in solid content of resist, mass%) | Acid Generator (ratio by mass) | Basic Compound | Surfactant | Solvent (ratio by mass) |
| Example | 1 | T-1 (94.5) | - | I-21 | N-2 | D-2 | S-1 |
| | 2 | T-1 (94.5) | - | I-11 | N-2 | D-2 | S-1 |
| | 3 | T-1 (84.5) | A-1 (0.1) (10.0) | I-4 | N-2 | D-2 | S-1 |
| | 4 | T-2 (94.5) | - | I-18 | N-1 | D-1 | S-1 |
| | 5 | T-3 (94.5) | - | I-14 | N-3 | D-3 | S-1 |
| | 6 | T-4 (94.5) | - | I-14 | N-1 | D-1 | S-1 |
| | 7 | T-4 (94.5) | - | I-21/I-25 (50/50) | N-1 | D-1 | S-1/S-2 (80/20) |
| | 8 | T-4 (84.5) | A-2 (0.1) (10.0) | I-14 | N-1 | D-1 | S-1 |
| | 9 | T-4 (74.5) | A-2(0.2) (20.0) | I-13 | N-1 | D-1 | S-1 |
| | 10 | T-4 (65.1) | A-2 (0.3) (30.0) | I-1 | N-1 | D-1 | S-1 |
| | 11 | T-4 (75.8) | A-2 (0.446) (44.5) | I-12/z2 (80/20) | N-1 | D-1 | S-1 |
| | 12 | T-5 (94.5) | - | I-16 | N-1 | D-3 | S-1 |
| | 13 | T-6 (94.5) | - | I-13 | N-2 | D-1 | S-1 |
| | 14 | T-7 (94.5) | - | I-12 | N-2 | D-3 | S-1 |
| | 15 | T-7 (94.5) | - | I-14/z2 (80/20) | N-3 | D-3 | S-1/S-3 (90/10) |
| | 16 | T-8 (59.5)<br>T-1 (20.0) | A-3 (0.15) (15.0) | I-37/I-6 (50/50) | N-3 | D-3 | S-1/S-3 (90/10) |
| | 17 | T-8 (54.5)<br>T-2 (20.0) | - | I-11 | N-3 | D-3 | S-1/S-3 (90/10) |
| | 18 | T-8 (65.0)<br>T-4 (19.5) | A-4 (0.1) (10.0) | I-92 | N-3 | D-4 | S-1/S-2 (80/20) |
| Comparative Example | 1 | T-1 (94.5) | - | za3 | N-2 | D-2 | S-1 |
| | 2 | T-3 (84.5) | A-1 (0.1) (10.0) | za2 | N-2 | D-2 | S-1 |
| | 3 | T-2 (94.5) | - | za3 | N-2 | D-2 | S-1 |
| | 4 | T-4 (94.5) | - | za1 | N-2 | D-2 | S-1 |
| | 5 | T-4 (46.0) | A-2 (0.486) (48.5) | za3 | N-1 | D-1 | S-1 |

(continued)

| | | Evaluation | | | | |
|---|---|---|---|---|---|---|
| | | Sensitivity (μC) | Resolving power (nm) | Pattern Profile | Line Edge Roughness (nm) | Outgassing (film loss) |
| Example | 1 | 8.5 | 85 | A | 7.0 | <0.005 |
| | 2 | 8.0 | 85 | A | 7.5 | <0.005 |
| | 3 | 8.5 | 90 | A | 7.0 | <0.005 |
| | 4 | 7.5 | 85 | A | 7.0 | <0.005 |
| | 5 | 8.0 | 90 | A | 7.5 | <0.005 |
| | 6 | 8.5 | 80 | A | 7.0 | <0.005 |
| | 7 | 8.5 | 90 | A | 7.5 | <0.005 |
| | 8 | 7.5 | 85 | A | 7.5 | <0.005 |
| | 9 | 8.5 | 85 | A | 7.0 | <0.005 |
| | 10 | 8.0 | 90 | A | 7.5 | <0.005 |
| | 11 | 7.5 | 90 | A | 7.0 | <0.005 |
| | 12 | 8.0 | 85 | A | 7.0 | <0.005 |
| | 13 | 8.0 | 90 | A | 7.5 | <0.005 |
| | 14 | 7.5 | 90 | A | 7.0 | <0.005 |
| | 15 | 8.5 | 85 | A | 7.0 | <0.005 |
| | 16 | 8.0 | 85 | A | 7.5 | <0.005 |
| | 17 | 7.5 | 85 | A | 7.0 | <0.005 |
| | 18 | 8.5 | 90 | A | 7.5 | <0.005 |
| Comparative Example | 1 | 12.0 | 115 | B | 7.5 | 0.03 |
| | 2 | 11.0 | 110 | B | 9.5 | 0.05 |
| | 3 | 12.5 | 115 | B | 10.0 | 0.03 |
| | 4 | 11.5 | 120 | B | 10.0 | 0.04 |
| | 5 | 12.0 | 115 | B | 9.5 | 0.03 |

The abbreviations in Table 2 indicate the followings. Additive Resin:

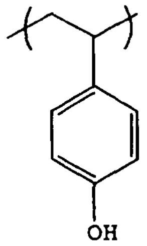

Weight average molecular weight: 7,500 Dispersity: 1.08

A-1

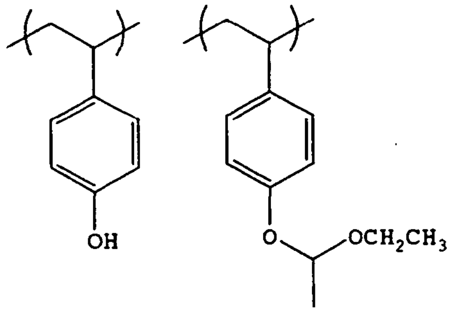

Weight average molecular weight: 7,800 Dispersity: 1.08
Acetal protection ratio: 35 mol%

A-2

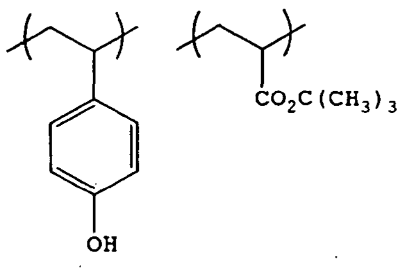

Weight average molecular weight: 13,000 Dispersity: 1.57
Compositional ratio (from left): 64/36

A-3

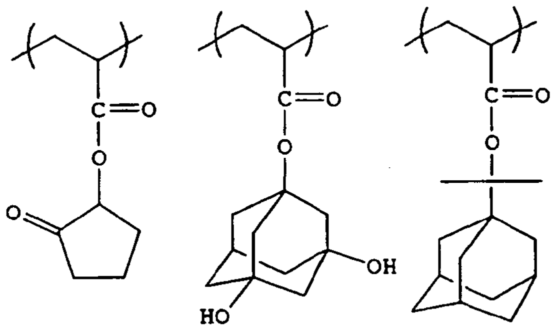

Weight average molecular weight: 8,600 Dispersity: 1.54
Compositional ratio (from left): 38/41/21

A-4

Acid Generator:

za1: triphenyl sulfonium nonaflate
za2: triphenyl sulfonium triflate
za3: triphenyl sulfonium 2,4,6-triisopropylbenzenesulfonate

Basic Compound:

N-1: trioctylamine
N-2: 1,5-diazabicyclo[4.3.0]-5-nonene
N-3: 2,4,6-triphenylimidazole

Surfactant:

D-1: Megafac F-176 (produced by Dainippon Ink & Chemicals, Inc.)
D-2: Megafac R08 (produced by Dainippon Ink & Chemicals, Inc.)
D-3: Troysol S-366 (produced by Troy Chemical Industries, Inc.)
D-4: polyoxyethylene lauryl ether

Solvent:

S-1: propylene glycol monomethyl ether acetate
S-2: propylene glycol monomethyl ether
S-3: ethyl lactate

As seen from the results shown in Table 2, the positive resist composition of the present invention exhibits excellent properties regarding the sensitivity, resolving power, pattern profile and line edge roughness.

This application is based on Japanese Patent application JP 2005-277528, filed September 26, 2005.

## Claims

1. A positive resist composition comprising:

(A) a compound having at least two acid-decomposable groups, an aromatic ring and an alkylene or cycloalkylene chain and having a molecular weight of 2,000 or less, of which solubility in an alkali developer increases under an action of an acid, wherein the content of the component (A) is from 65 to 95 mass% based on the solid content of the positive resist composition; and
(B) a compound represented by the following formula (B-1), which generates an acid upon irradiation with actinic rays or radiation:

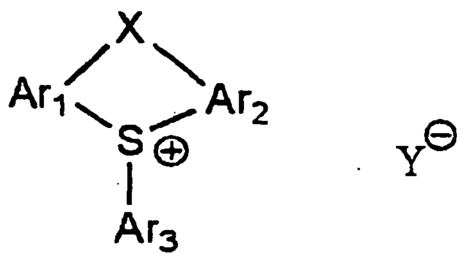

(B-I)

wherein $Ar_1$ to $Ar_3$ each independently represents an aromatic ring having a carbon number of from 6 to 20, which may be a substituted or unsubstituted one, provided that at least one of $Ar_1$, $Ar_2$ and $Ar_3$ has a $-Q-SO_2Ra$ group or a -Q-CORb group as a substituent, in which Ra and Rb each independently represents an alkyl group or an aryl group, Q represents an oxygen atom or -N(Ry)-, Ry represents a hydrogen atom, an alkyl group or a cycloalkyl group, and Ra, Rb and Ry may be substituted or unsubstituted,

X represents a single bond or a divalent linking group, and
Y represents a sulfonate anion, a carboxylate anion, a bis(alkylsulfonyl)amide anion or a tris(alkylsulfonyl)-methide anion.

2. The positive resist composition as claimed in claim 1, wherein $Ar_3$ in the formula (B-1) has a $-Q-SO_2Ra$ group or a

-Q-CORb group.

3. The positive resist composition as claimed in claim 1, which further comprises: a resin of which solubility in an alkali developer increases under an action of an acid.

4. The positive resist composition as claimed in claim 1, which further comprises: a resin having solubility in an alkali developer.

5. The positive resist composition as claimed in claim 1, wherein the compound (A) is a compound having a calixarene structure.

6. The positive resist composition as claimed in claim 1, which further comprises: a nitrogen-containing basic compound.

7. The positive resist composition as claimed in claim 6, wherein the nitrogen-containing basic compound comprises a structure represented by the following formula (A), (B), (C), (D) or (E):

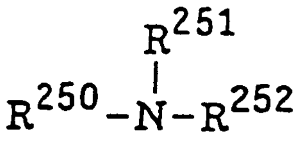

(A)

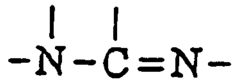

(B)

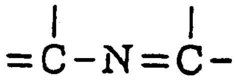

(C)

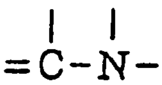

(D)

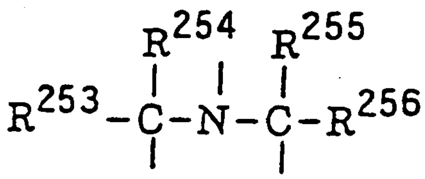

(E)

wherein $R^{250}$, $R^{251}$ and $R^{252}$ each independently represents a hydrogen atom, an alkyl group having a carbon number of from 1 to 20, a cycloalkyl group having a carbon number of from 3 to 20 or an aryl group having a carbon number of from 6 to 20, in which $R^{251}$ and $R^{252}$ may combine with each other to form a ring, and the alkyl group, the cycloalkyl group and the aryl group each may have a substituent, and $R^{253}$, $R^{254}$, $R^{255}$ and $R^{256}$ each independently represents an alkyl group having a carbon number of from 1 to 20.

8. The positive resist composition as claimed in claim 1, which further comprises: a surfactant.

9. A pattern forming method comprising: forming a resist film from the positive resist composition claimed in claim 1; exposing the resist film; and developing the resist film.

**Patentansprüche**

1. Positive Fotolackzusammensetzung, umfassend:

(A) eine Verbindung, die mindestens zwei Säurezersetzbare Gruppen, einen aromatischen Ring und eine Alkylen- oder Cycloalkylenkette aufweist und die ein Molekulargewicht von 2.000 oder weniger aufweist, deren Löslichkeit in einem Alkali-Entwickler sich unter der Wirkung einer Säure erhöht, und worin der Gehalt der Komponente (A) von 65 bis 95 Masse% beträgt, bezogen auf den Feststoffgehalt der positiven Fotolackzusammensetzung; und
(B) eine Verbindung, die durch die folgende Formel (B-1) dargestellt ist, welche durch Bestrahlung mit aktinischen Strahlen oder Strahlung eine Säure generiert:

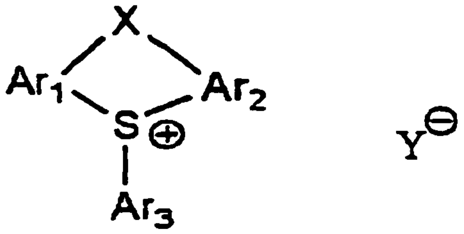

(B-I)

worin $Ar_1$ bis $Ar_3$ jeweils unabhängig einen aromatischen Ring mit einer Kohlenstoffanzahl von 6 bis 20 darstellen, der substituiert oder unsubstituiert sein kann, vorausgesetzt, dass mindestens eines von $Ar_1$, $Ar_2$ und $Ar_3$ eine $-Q-SO_2Ra$-Gruppe oder eine -Q-CORb-Gruppe als einen Substituenten aufweist, worin Ra und Rb jeweils unabhängig voneinander eine Alkylgruppe oder eine Arylgruppe darstellen, Q ein Sauerstoffatom oder -N(Ry)- darstellt, Ry ein Wasserstoffatom, eine Alkylgruppe oder eine Cycloalkylgruppe darstellt, und Ra, Rb und Ry substituiert oder unsubstituiert sein können,

X eine Einfachbindung oder eine divalente Verknüpfungsgruppe darstellt, und
Y ein Sulfonatanion, ein Carboxylatanion, ein Bis(alkylsulfonyl)amidanion oder ein Tris(alkylsulfonyl)methidanion darstellt.

**2.** Positive Fotolackzusammensetzung gemäß Anspruch 1, worin $Ar_3$ in der Formel (B-1) eine $-Q-SO_2Ra$-Gruppe oder eine -Q-CORb-Gruppe aufweist.

**3.** Positive Fotolackzusammensetzung gemäß Anspruch 1, die ferner umfasst: ein Harz, dessen Löslichkeit in einem Alkali-Entwickler sich unter der Wirkung einer Säure erhöht.

**4.** Positive Fotolackzusammensetzung gemäß Anspruch 1, die ferner umfasst: ein Harz mit Löslichkeit in einem Alkali-Entwickler.

**5.** Positive Fotolackzusammensetzung gemäß Anspruch 1, worin die Verbindung (A) eine Verbindung mit einer Calixaren-Struktur ist.

**6.** Positive Fotolackzusammensetzung gemäß Anspruch 1, die ferner umfasst: eine stickstoffhaltige basische Verbindung.

**7.** Positive Fotolackzusammensetzung gemäß Anspruch 6, worin die stickstoffhaltige basische Verbindung eine durch die folgende Formel (A), (B), (C), (D) oder (E) dargestellte Struktur umfasst:

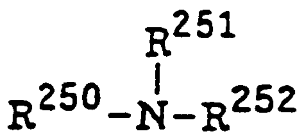

(A)

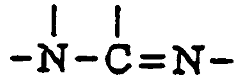

(B)

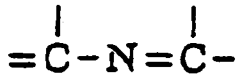

(C)

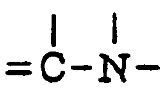

(D)

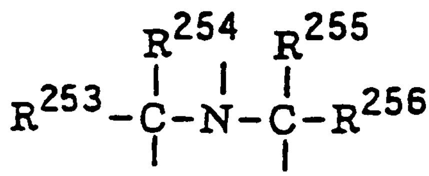

(E)

worin $R^{250}$, $R^{251}$, und $R^{252}$ jeweils unabhängig voneinander ein Wasserstoffatom, eine Alkylgruppe mit einer Kohlenstoffanzahl von 1 bis 20, eine Cycloalkylgruppe mit einer Kohlenstoffanzahl von 3 bis 20 oder eine Arylgruppe mit einer Kohlenstoffanzahl von 6 bis 20 darstellen, $R^{251}$ und $R^{252}$ miteinander verbunden sein können, um einen

Ring zu bilden, und die Alkylgruppe, die Cycloalkylgruppe und die Arylgruppe jeweils einen Substituenten aufweisen können, und $R^{253}$, $R^{254}$, $R^{255}$ und $R^{256}$ jeweils unabhängig voneinander eine Alkylgruppe mit einer Kohlenstoffanzahl von 1 bis 20 darstellen.

**8.** Positive Fotolackzusammensetzung gemäß Anspruch 1, die ferner umfasst: ein Tensid

**9.** Mustererzeugungsverfahren, umfassend: Bilden eines Fotolackfilms aus der positiven Fotolackzusammensetzung gemäß Anspruch 1; Belichten des Fotolackfilms; und Entwickeln des Fotolackfilms.

**Revendications**

**1.** Composition de réserve positive, comprenant :

(A) un composé ayant au moins deux radicaux décomposables en milieu acide, un cycle aromatique et une chaîne alkylène ou cycloalkylène et ayant un poids moléculaire de 2000 ou moins, dont la solubilité dans un agent de développement alcalin augmente sous l'action d'un acide, et où la teneur en composant (A) se situe dans l'intervalle allant de 65 à 95% en masse, sur base de la teneur en matières solides de la composition de réserve positive, et
(B) un composé représenté par la formule générale (B-1) suivante, qui génère un acide par irradiation avec des rayons actiniques ou un rayonnement :

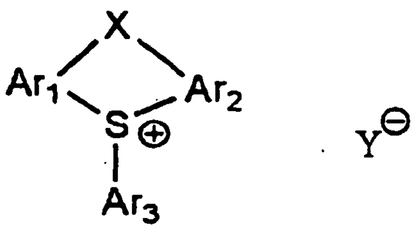

(B-I)

où $Ar_1$ à $Ar_3$ représentent chacun indépendamment, un cycle aromatique ayant 6 à 20 atomes de carbone, qui peut être substitué ou non substitué, pourvu qu'au moins l'un de $Ar_1$, $Ar_2$ et $Ar_3$ porte un radical $-Q-SO_2Ra$ ou un radical -Q-CORb comme substituant, où Ra et Rb représentent chacun indépendamment, un radical alkyle ou un radical aryle, Q représente l'atome d'oxygène ou -N(Ry)-, Ry représente l'atome d'hydrogène, un radical alkyle ou un radical cycloalkyle, et Ra, Rb et Ry peuvent être substitués ou non substitués ;

X représente une simple liaison ou un radical bivalent de liaison, et
Y représente un anion sulfonate, un anion carboxylate, un anion bis(alkylsulfonyl)amide ou un anion tris (alkylsulfonyl) méthide.

**2.** Composition de réserve positive selon la revendication 1, où $Ar_3$ dans la formule (B-1) porte un radical $-Q-SO_2Ra$ ou un radical -Q-CORb.

**3.** Composition de réserve positive selon la revendication 1, qui comprend en outre, une résine dont la solubilité dans un agent de développement alcalin augmente sous l'action d'un acide.

**4.** Composition de réserve positive selon la revendication 1, qui comprend en outre, une résine ayant une certaine solubilité dans un agent de développement alcalin.

**5.** Composition de réserve positive selon la revendication 1, où le composé (A) est un composé ayant une structure calixarène.

**6.** Composition de réserve positive selon la revendication 1, qui comprend en outre, un composé basique azoté.

**7.** Composition de réserve positive selon la revendication 6, où le composé basique azoté comprend une structure représentée par l'une des structures (A), (B), (C), (D) ou (E) suivantes :

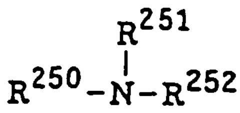
(A)

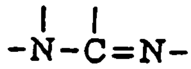
(B)

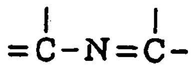
(C)

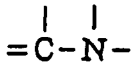
(D)

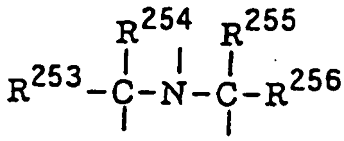
(E)

où $R^{250}$ $R^{251}$ et $R^{252}$ représentent chacun indépendamment, l'atome d'hydrogène, un radical alkyle ayant 1 à 20 atomes de carbone, un radical cycloalkyle ayant 3 à 20 atomes de carbone, un radical aryle ayant 6 à 20 atomes de carbone, où $R^{251}$ et $R^{252}$ peuvent se combiner l'un avec l'autre pour former un cycle, et le radical alkyle, le radical cycloalkyle et le radical aryle peuvent porter chacun, un substituant, et $R^{253}$, $R^{254}$, $R^{255}$ et $R^{256}$ représentent chacun indépendamment, un radical alkyle ayant 1 à 20 atomes de carbone.

**8.** Composition de réserve positive selon la revendication 1, qui comprend en outre, un tensioactif.

**9.** Procédé de formation de motif comprenant : la formation d'un film de réserve à partir de la composition de réserve positive selon la revendication 1, l'exposition du film de réserve et le développement du film de réserve.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 10083073 A
- JP 2000305270 A
- JP 2003183227 A
- JP 10120610 A
- JP 11322656 A
- JP 2003321423 A
- JP 10310545 A
- US 6197473 B
- EP 1703326 A
- US 3849137 A
- DE 3914407
- JP 63026653 A
- JP 55164824 A
- JP 62069263 A
- JP 63146038 A
- JP 63163452 A
- JP 62153853 A
- JP 63146029 A
- US 3779778 A
- EP 126712 A
- JP 62036663 A
- JP 61226746 A
- JP 61226745 A
- JP 62170950 A
- JP 63034540 A
- JP 7230165 A
- JP 8062834 A
- JP 9054432 A
- JP 9005988 A
- JP 2002277862 A
- US 5405720 A
- US 5360692 A
- US 5529881 A
- US 5296330 A
- US 5436098 A
- US 5576143 A
- US 5294511 A
- US 5824451 A
- JP 2002090991 A
- JP 4151156 A
- JP 4162040 A
- JP 5197148 A
- JP 5005995 A
- JP 6194834 A
- JP 8146608 A
- JP 10083079 A
- EP 622682 A
- JP 7069611 B
- US 5294680 A
- JP 6118631 A
- JP 6118656 A
- JP 8087115 A
- JP 8179509 A
- JP 2005277528 A